(19) Europäisches Patentamt
European Patent Office
Office européen des brevets

(11) **EP 3 931 624 B1**

(12) **EUROPEAN PATENT SPECIFICATION**

(45) Date of publication and mention
of the grant of the patent:
**28.08.2024 Bulletin 2024/35**

(21) Application number: **20762994.0**

(22) Date of filing: **23.02.2020**

(51) International Patent Classification (IPC):
$G02B\ 27/10^{(2006.01)}$      $G02B\ 17/08^{(2006.01)}$
$G02B\ 27/42^{(2006.01)}$      $H01S\ 5/40^{(2006.01)}$
$G02B\ 6/293^{(2006.01)}$      $G02B\ 27/09^{(2006.01)}$
$G02B\ 27/12^{(2006.01)}$      $H01S\ 3/00^{(2006.01)}$
$H01S\ 3/067^{(2006.01)}$      $H01S\ 3/13^{(2006.01)}$
$H01S\ 3/23^{(2006.01)}$       $G02B\ 5/18^{(2006.01)}$

(52) Cooperative Patent Classification (CPC):
**G02B 27/1006; G02B 5/1819; G02B 6/29305;
G02B 6/29308; G02B 6/2938; G02B 27/0905;
G02B 27/0944; G02B 27/1086; G02B 27/1093;
G02B 27/123;** H01S 3/005; H01S 3/067;
H01S 3/1307; H01S 3/2391

(86) International application number:
**PCT/IL2020/050195**

(87) International publication number:
**WO 2020/174461 (03.09.2020 Gazette 2020/36)**

(54) **SYSTEMS, DEVICES AND METHODS FOR OPTICAL BEAM COMBINING**

SYSTEME, VORRICHTUNGEN UND VERFAHREN ZUR KOMBINATION OPTISCHER STRAHLEN

SYSTÈMES, DISPOSITIFS ET PROCÉDÉS DE COMBINAISON DE FAISCEAUX OPTIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.02.2019 IL 26502719
02.12.2019 IL 27113019**

(43) Date of publication of application:
**05.01.2022 Bulletin 2022/01**

(73) Proprietor: **Elbit Systems Electro-Optics Elop Ltd.
7670305 Rehovot (IL)**

(72) Inventors:
 • **SCHIFFER, Zeev**
  **7670305 Rehovot (IL)**
 • **LEVY, Daniel**
  **7670305 Rehovot (IL)**
 • **MAROM, Ran Zvi**
  **7670305 Rehovot (IL)**

(74) Representative: **ABG Intellectual Property Law,
S.L.
Avenida de Burgos, 16D
Edificio Euromor
28036 Madrid (ES)**

(56) References cited:
**WO-A1-00/29888          WO-A2-2007/100752
CN-A- 101 159 365      CN-A- 107 240 856
CN-A- 107 240 856      US-A1- 2004 141 681
US-A1- 2017 082 863   US-A1- 2017 082 863
US-A1- 2018 329 216**

 • **AUGST S J ET AL: "Coherent and spectral beam
combining of fiber lasers", FIBER LASERS IX:
TECHNOLOGY, SYSTEMS, AND APPLICATIONS,
SPIE, 1000 20TH ST. BELLINGHAM WA
98225-6705 USA, vol. 8237, no. 1, 8 March 2012
(2012-03-08), pages 1 - 10, XP060023354, DOI:
10.1117/12.905759**

**Description**

The present disclosure relates in general to devices, apparatuses, systems and components for combining of multiple optical beams.

**BACKGROUND**

Optical amplifiers are vastly used in many systems for a growing number of industries and applications, especially for systems requiring high power laser output.

Optical amplifiers are devices or systems that enable amplification of optical signals by using optical instrumentation and/or elements, without requiring conversion of the optical signal to be amplified, to non-optical signals such as to electrical signals, and then back to optical signals. Several methods for optical amplification include doped fiber amplification (DFA), in which one or more doped optical waveguides such as double clad doped optical fibers are used for power scaling of optical input. One type of DFA includes fiber lasers, using doped optical fibers as gain medium.

PCT patent application publication No. WO2007100752A2 to Northrop Grumman teaches an optical beam combiner and a related method for its operation, in which multiple coherent input beams are directed onto a diffractive optical element (DOE) along directions corresponding to diffraction orders of the DOE, such that the DOE generates a single output beam in a direction corresponding to a desired diffraction order, and suppresses outputs in directions corresponding to unwanted diffraction orders. The phases of the input beams are actively controlled to ensure and maintain the condition that only a single diffraction mode is present in the output of the DOE.

Chinese patent application No. CN101159365A to Chinese PLA air force engineer teaches a multi-channel optical-fiber laser coherence beam combination device and a coherence beam combination method based on overlapped body grating. The device comprises an optical-fiber coupler, a doping double-clad optical-fiber, a lens, a dichroiscope, a reflector, a polarization controller, a reflector, an overlapped body grating and an output coupling mirror connected in sequence at one side of the optical-fiber grating. The method is able to realize the multi-channel optical-fiber laser coherence beam combination without complex phase detection and control to each beam. The phases of each beam realize interlocking by sharing a resonator composed of the output coupling mirror and the optical-fiber grating. Each beam realizes the coherent superposition in the near-field and far-field to significantly enhance the output power and the brightness of the optical-fiber laser through the overlapped body of grating. The invention features the simple structure and complex structure without increasing as the increase of the beam combination laser, and is able to be widely applied in the field needing the large power optical-fiber laser as the light source, thereby capable of gaining the large power, high beam quality as well as compact high-energy laser system.

Article "Coherent and Spectral Beam Combining of Fiber Lasers" to J. Augst, S. M. Redmond, C. X. Yu, D. J. Ripin, T. Y. Fan, G. D. Goodno§, P. A. Thielen§, J. E. Rothenberg§ and A. Sanchez § Northrop Grumman Aerospace Systems, One Space Park, Redondo Beach, CA 90278, MIT Lincoln Laboratory, 244 Wood St., Lexington, MA 02420 teaches a diffraction-limited fiber lasers capable of producing kilowatts of power. Power levels produced by single elements are gradually increasing but beam combining techniques are attractive for rapidly scaling fiber laser systems to much higher power levels. We discuss both coherent and spectral beam combining techniques for scaling fiber laser systems to high brightness and high power. Recent results demonstrating beam combination of 500-W commercial fiber laser amplifiers will be presented.

US patent application No. US2017082863A1 to Marciante John R teaches a multispectral beam combiner that includes a prism body having an output surface, a fiber entry block attached to the prism body, and a plurality of input fibers attached to the fiber entry block. Each of the plurality of input fibers is operable to support a different wavelength. The multispectral beam combiner also includes a collimator attached to the prism body. The collimator is operable to reflect and collimate light propagating from the fiber entry block. The multispectral beam combiner further includes an immersion grating operable to diffract light propagating from the collimator. The output surface of the prism body is operable to pass light propagating from the immersion grating.

US patent application No.: US2004141681A1 to Weverka Rober T teaches a wavelength router that selectively directs spectral bands between an input port and a set of output ports. The router includes a free-space optical train disposed between the input ports and said output ports, and a routing mechanism. The free-space optical train can include air-spaced elements or can be of generally monolithic construction. The optical train includes a dispersive element such as a diffraction grating, and is configured so that the light from the input port encounters the dispersive element twice before reaching any of the output ports. The routing mechanism includes one or more routing elements and cooperates with the other elements in the optical train to provide optical paths that couple desired subsets of the spectral bands to desired output ports. The routing elements are disposed to intercept the different spectral bands after they have been spatially separated by their first encounter with the dispersive element.

PCT application publication No. WO 00/29888A1 teaches an optical multiplexing and demultiplexing device including a fiber mounting assembly for aligning optical fibers, a set of collimating and focusing optics, a transmission grating element, and a mirror element. The fiber mounting assembly alignment element aligns a series substantially close-spaced optical fibers with their ends flush and assembled in a substantially straight line. The optical fibers are either multi-mode or single mode communication fibers capable of transmitting optical wavelengths with substantially high transmittance. The set of collimating and focusing optics, preferably a lens (or mirror) system that contains two (2) or more elements, may be made from optical glasses with uniform refractive indices, optical glasses with gradient indices, plastic optical elements, or diffractive lenses. The transmission grating element can be made from holographic techniques utilizing photosensitive media, where the media having sufficient thickness to provide high diffractive efficiency and wide operation waveband. The photosensitive media providing high spatial resolution in order to generate high groove density-thus high spectral resolution for DWDM applications. The mirror element, having a high reflectance coating for the wavelengths of interest, is arranged at such an angle that the optical radiation will be reflected back to the grating. It will then be diffracted again by the grating then focused to the optical fibers.

Patent application No. CN107240856A to Yu Na et al. discloses a spectrum beam combination device for realizing twice diffraction by using the transmission grating of a plated reflecting film. The spectrum beam combination device comprises a semiconductor laser unit light source, a slow-axis collimated column lens, a conversion lens, a transmission grating and an output coupling mirror. The transmission grating of the back plated reflecting film is used as a diffraction element, namely the reflecting film is plated at the back of a grating surface, so that the dispersive power of the grating can be doubled by an incident beam through the diffraction of the transmission grating twice. According to the spectrum beam combination device, the restriction that the dispersive power of the diffraction grating is limited in traditional spectrum beam combination is overcome, the number of beam combination elements can be increased in the gain line width of the material and the high-efficiency diffraction wavelength range of the grating, and the output power is obviously improved, or the length of a resonant cavity can be shortened when certain output spectrum width is guaranteed, so that the structure of a laser unit is compacter, and the mode of the laser unit is stabler.

## SUMMARY

The invention is set out in the appended set of claims.

## BRIEF DESCRIPTION OF THE FIGURES

The figures illustrate generally, by way of example, but not by way of limitation, various embodiments, as well as various examples, some of which do not fall under the scope of the claims, discussed in the present document.

For simplicity and clarity of illustration, elements shown in the figures have not necessarily been drawn to scale. For example, the dimensions of some of the elements may be exaggerated relative to other elements for clarity of presentation. Furthermore, reference numerals may be repeated among the figures to indicate corresponding or analogous elements. References to previously presented elements are implied without necessarily further citing the drawing or description in which they appear. The figures are listed below.

**FIG. 1** shows a background art setup for coherent beam combing.

**FIG. 2** shows a general layout of a coherent beam combining system for combining multiple optical beams emanating from multiple optical fibers that includes a monolithic body and an optical element having a phase mask.

**FIG. 3A** shows a diagram illustrating a general optical effect of a beam splitter for illustrating how a beam splitter can be used as a diffraction optical element.

**FIG. 3B** shows a diagram illustrating a cross section etching pattern of a phase mask of an exemplary beam splitter.

**FIG. 3C** shows high order side lobes of beams split by the beam splitter, according to the phase mask given in **FIG. 3B.**

**FIG. 4** shows a general layout of a coherent beam combining system for combining multiple optical beams emanating from multiple optical fibers that includes a monolithic body having a phase mask embedded over an output surface thereof.

**FIG.5** shows a coherent beam combining system using a monolithic body with a lens-shaped output surface and a separated (non-coupled) optical element.

**FIG. 6** shows a coherent beam combining system using a monolithic body with an inner reflective surface and a phase mask that is etched, embossed or adhered over an output surface thereof.

**FIG.7** shows a coherent beam combining system using a monolithic body with a curved input surface and a phase mask that is etched, embossed or adhered over an output surface thereof.

**FIG. 8** shows a coherent beam combining device that includes a monolithic body having a gradually varying refractive indexing configuration.

**FIG. 9** shows a system for coherent beam combining having multiple beam combing devices.

**FIG. 10A** shows a background art optical setup for spectral beam combining, using a single diffraction grating element.

**FIG. 10B** shows a background art optical setup for spectral beam combining, using two diffraction grating elements.

**FIG. 11** shows a spectral beam combining device, using a monolithic body with a single diffractive surface and a reflective surface parallel thereto, according to some embodiments.

**FIG. 12** shows a spectral beam combining device, using a monolithic body with a single diffractive surface and a reflective surface angular thereto, according to some embodiments.

**FIG. 13** shows a spectral beam combining device, using a monolithic body with a single diffractive surface and multiple reflective surfaces, according to some embodiments.

**FIG. 14** shows a system for spectral combining of spectrally differentiated optical beams emanating from a plurality of coherent beam combining devices.

**FIG. 15** shows a flowchart of a method for coherent beam combining.

**FIG. 16** shows a flowchart of a method for spectral beam combining using a device of claim 1.

**FIG. 17** shows a flowchart of a method for cascaded beam, which may use at least one device of claim 1.

## DETAILED DESCRIPTION

Aspects of disclosed embodiments and examples pertain to devices and system for optical amplification by combining of multiple beams emanating from multiple light sources such as from multiple optical fibers.

Fiber lasers, used as optical amplifiers for power scaling, use one or more optical fibers such as doped optical fibers (also referred to as "doped fibers") as their gain medium. Beam quality and/or maximal gain power of the output beam of a fiber laser may be influenced by several physical effects such as stimulated Brillouin scattering (SBS), stimulated Raman scattering (SRS) and/or modal thermal instabilities. These effects may limit physical properties of the fiber laser output beam such as limit the output beam quality and/or maximal output beam power.

The term "doped optical fiber" relates to any type of optical fiber doped with one or more elements such as, yet not limited to, erbium, dysprosium, ytterbium, neodymium, thulium, praseodymium, and/or holmium.

The term "optical beam" or "beam" used (interchangeably) herein may refer to any propagating electromagnetic signal, field and/or wave in the optical wavelengths range.

The term "beam quality" may relate to any one or more beam characteristics, such as, yet not limited to: wave front (profile) quality, beam waste, beam radius, beam divergence, beam intensity/amplitude, beam brightness level (radiance), phase deviation (phase coherence), and the like and/or the maintaining over time and/or distance of these beam characteristics.

To overcome some of the limiting physical effects in fiber lasers or in other DFA based devices and systems such as output power and/or near diffraction beam quality limitations, beam combining may be used, involving combining of a multiplicity of optical beams optionally emanating from several optical waveguides (such as core doped or any other type of optical fibers) into a single optical beam at least for improving power scaling and/or beam quality.

Two beam combining techniques may be used: spectral beam combining (SBC) and coherent beam combining (CBC).

SBC may be generally described as combining of multiple beams emanating from multiple beam sources, where the beams are of different wavelengths (e.g. non-overlapping or partially overlapping wavelength bands). For SBC, the layout of optical elements used for combining (i.e. the spectral combiner device or spectral combiner) should be wavelength-sensitive and configured for enabling all beams to eventually propagate at the output thereof, in the same propagation direction forming a wide-band output beam that propagates in a single unified outward direction. SBC devices may be configured for maintaining wavelengths of all entering beams.

CBC may be generally described as a method for combining coherent optical beams having similar, overlapping or identical wavelengths or wavelength narrow bands for outputting an (e.g., power-scaled) coherent narrow-band output beam propagating in a single unified outward direction, e.g., by controlling the phase of the entering beams, for example, to obtain constructive interference at the output. In CBC, at the input, the coherent optical beams may have (substantially) identical phases.

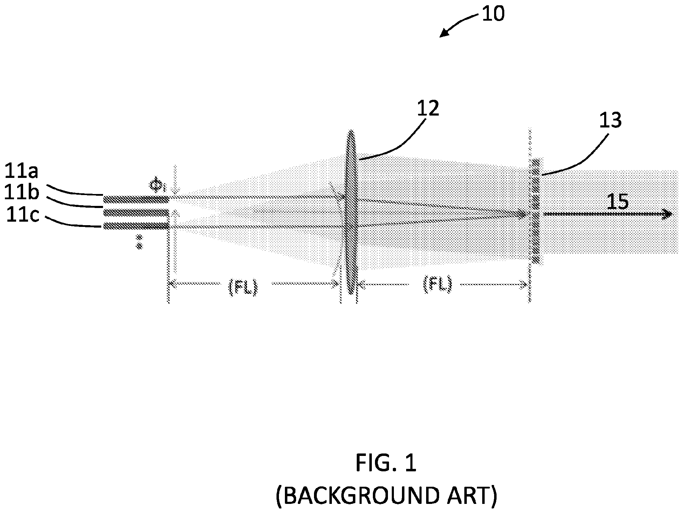

FIG. 1 shows an optional layout of a background art CBC optical system **10** for combining multiple beams (which may be of coherent i.e. of similar, identical or overlapping wavelengths) emanating from multiple optical fibers **11a, 11b** and **11c,** having a collimating lens **12** for focusing the beams to a single focal plane, where a diffraction grating element (DOE) **13** is positioned, for combining the collimated beams into a single combined output beam **15.** The elements of this CBC optical system **10** i.e. the lens **12** fibers **11a-11c** and the DOE **13** are all separated from one another and therefor require holding each element in position for alignment thereof in a separated manner. This configuration is extremely sensitive to physical instabilities since it requires a high level of alignment between all the optical elements of the CBC optical system **10,** in order to produce and maintain a high output beam quality. Any movements such as slight quakes of the lens **12,** DOE **13** and/or displacements of the optical fibers **10a-10c** output surfaces relative to each other can affect the entire combining process and quality.

Aspects of disclosed examples, which do not fall under the scope of the claims, pertain to beam combining devices for coherent beam-combining of multiple optical beams (herein "entering beams") emanating from a plurality of optical fibers including at least: a monolithic body and a phase mask configured for CBC of the entering beams, to form a single combined optical beam outputted therefrom (herein "output beam").

According to some examples, the monolithic body may be configured for focusing all entering beams into a single focal point, where the phase mask may be positioned over a plane that includes the focal point. For example, the monolithic body may be configured such that the entering beams directed therethrough converge at the focal point at the same exit separation angle from one another, such that the separation angle and the focal point define a focal plane over which the phase mask is positioned

The phase mask may be an integral part of the monolithic body or embedded in a separate optical element. In cases in which a separate optical element is used, the optical element, having the phase mask embedded therein, may be positioned at distance from the monolithic body and externally thereto, when the monolithic body is configured such that the focal point and focal plane are external thereto, or coupled to at least one side of the monolithic body, in cases in which the focal plane is located over one side of the monolithic body.

The disclosed CBC device examples are designed for providing improved stability of each CBC device's components in respect to one another in order to reduce or prevent output beam quality reduction caused by physical relative movements at least between some of those components. Other advantages of the disclosed CBC devices may include enabling using an increased number of optical fibers and therefore increase the gain (output power), while keeping high output beam quality.

In some embodiments and examples, the relative movements between the monolithic body and the plurality of optical fibers may be reduced or prevented by fixedly connecting those optical fibers to the monolithic body, e.g. by welding, fusing, splicing or any other form of fixed connection of the fibers to the monolithic body

Additionally or alternatively, the monolithic body may be designed such as to incorporate one or more collimating lenses as an integral part of the monolithic body for preventing relative movements therebetween. Additionally or alternatively, the OE(s) of the CBC device may be integrally or non-integrally (yet, e.g., fixedly) attached to the output surface of the monolithic body for preventing relative movements thereof.

The CBC device may also be specifically designed to fit the number of entering beams, their separation angles as well as to one or more properties of each of the entering beams, such as wavelength, wavelengths band, phase, amplitude, polarization, beam radius, beam coherence, etc.

According to some embodiments and examples, each optical fiber may be operatively associated with (e.g. connected to) a light source, at an input end thereof, and output light guided thereby, from an output end thereof. The beam of light outputted from the output end of the optical fiber may be referred to as the entering beam thereof, as it enters the monolithic body.

According to some embodiments and examples, the monolithic body may be a three-dimensional (3D) object that is at least partially transparent, having at least an input surface and an output surface. The input surface may be configured to fixedly connect to the plurality of optical fibers (e.g. by fusion, welding, slicing, gluing, etc.), where the geometry of the monolithic body may be configured to direct a plurality of entering beams of light, entering thereinto from the plurality of optical fibers, towards an output surface thereof.

According to some embodiments and examples, the optical fibers connections to the input surface of the monolithic body may define "engagements spots" which may be points or areas over the input surface of the monolithic body, engaging the output ends of the optical fibers. The connection or engagement between the output ends of the optical fibers and the input surface of the monolithic body, may create (substantially) equal spacing between each couple of adjacent engagement spots, causing the entering beams to enter the monolithic body at specific desired entrance angles (e.g. in respect to a main axis) such that the relative angle between each couple of adjacent beams (defined as the " entry separation angle") is equal for each couple of adjacent beams, i.e. the entering beams enter the monolithic body, via the input surface thereof, at equal "entry separation angles" from one another.

According to some examples, the monolithic body may be configured such that the beams directed thereby, exit the output surface thereof at the same exit separation angle from one another and the phase mask may be designed in correspondence with the exit separation angle of the exiting beams.

According to some embodiments and examples, the optical fibers, fixedly connecting to the input surface of the monolithic body may be an integral part of the beam combining device.

The optical fibers may be doped optical fibers and/or may be double cladded.

According to some embodiments and examples, the monolithic body has the monolithic body has one or more additional surfaces other than the input and output surfaces.

According to some embodiments and examples, the input surface or output surface may be curved, concaved or flat (also: straight).

The term "surface" used herein may relate to any type or shape of a surface such as a flat surface, a curved surface and the like.

According to some embodiments and examples, the input surface of the monolithic body may be smoothed (polished) for improving engagement between the input surface and the output end of the optical fibers connecting thereto.

The monolithic body may be made from any transparent or partially transparent material such as glass, silica fused glass, acrylic glass, etc.

According to some embodiments and examples, the monolithic body may be made from a transparent material of a single refractive index.

According to other embodiments and examples, the monolithic body may be made from a fully or partially transparent material having more than one refraction indices e.g. by having a gradient indexing or by having discretely varying indexing in different areas (volumes) in the monolithic body.

According to some embodiments and examples, the properties of the monolithic body such as geometry, dimensions, refraction indexing, transparency and clarity rate, shape and dimensions etc. may all be designed and adapted for guiding entering beams from the input surface towards the output surface thereof in a certain manner such that the exiting beams exiting the output surface exit at desired exit angle in respect to a main axis (e.g. to fit the exit separation angle required by the design of the phase mask) and/or for converging the entering beams for focusing thereof into a single focal point. The properties of the monolithic body may also be adapted according to the manner in which the optical fibers are to engage the inner surface, the properties of the entering beams such as wavelength, beam dispersion etc. entry separation angle, as well as to the phase mask properties such as phase mask profile, positioning in relation to the output surface, size and dimensions etc.

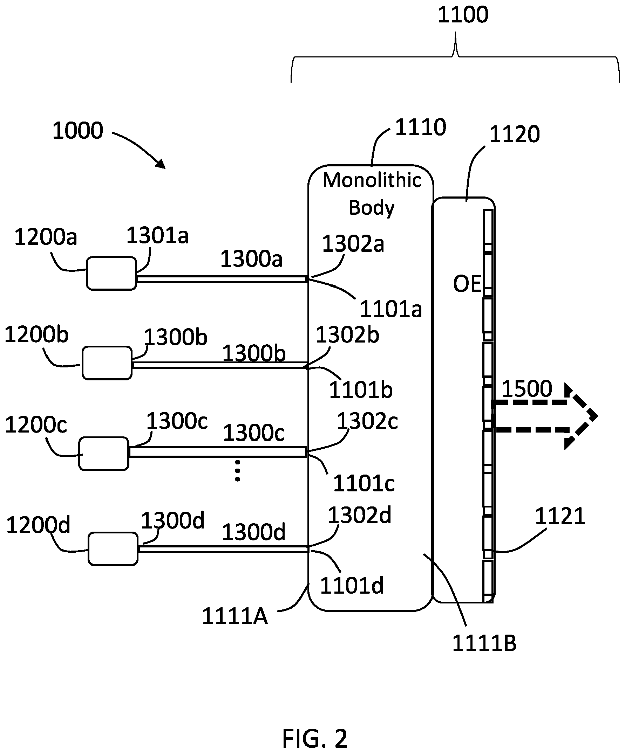

Reference is made to **FIG. 2** illustrating a CBC system **1000** for combining multiple optical beams emanating from multiple optical fibers, according to some examples, which do not fall under the scope of the claims. The CBC system **1000** may include: a beam combining device **1100,** multiple light sources, such as light sources **1200a, 1200b, 1200c** and **1200d,** and multiple optical fibers such as optical fibers **1300a, 1300b, 1300c** and **1300d,** each optical fiber **1300a/1300b/1300c/1300d** being fixedly connectable to the beam combining device **1100** and may be an integral part thereof.

According to some examples, the beam combining device **1100** may include a monolithic body **1110** and one or more optical elements such as optical element (OE) **1120** having a phase mask, e.g. by having the phase mask etched, engraved, embossed or adhered to one side (surface) of the OE **1120.**

The monolithic body **1110** may be a 3D fully transparent or partially transparent element having an input surface **1111A** and an output surface **1111B** (side). The monolithic body **1110** may be configured to direct entering optical beams of light (herein also "entering beams"), outputted from output ends of the optical fibers **1300a-1300d** and entering the monolithic body **1110** from the input surface **1111A** thereof, towards the output surface **1111B.** The OE **1120** may be coupled to the output surface **1111B** of the monolithic body **1110** or located at a short distance from the output surface **1111B** of the monolithic body **1110** (i.e. in a non-coupled position), and configured for combining light beams exiting the output surface **1111B** (herein "exiting beams" or "exiting optical beams"). The OE **1120** features such as diffraction configuration, diffractive surface(s) design, dimensions and distance from the output surface **1111B** of the monolithic body **1110,** etc., may be designed to achieve optimal beam combining and may correspond to the design of the monolithic body **1110** as well as to beam properties of each of the entering and/ exiting beams such as the wavelength, wavelength band, beam radius, beam dispersion, beam power, amplitude, polarization, etc. i.e. the properties of the beams when entering the input surface **1111A.**

The beam properties of the exiting beams may be related to (i.e. dependent on) the beam properties of the entering beams (as outputted by the optical fibers) as well on the configuration of the monolithic body and the manner in which the optical fibers are connected to its input surface.

The properties of the entering and/or exiting beams may be known in advance for each CBC system **1000** such that the designs of the monolithic body **1110** and/or the OE **1120** and/or their relative positioning may be arranged for each CBC system requirements and features.

According to some examples, each optical fiber **1300a, 1300b, 1300c** or **1300d** may direct light originating from a respective light source **1200a, 1200b, 1200c** or **1200d** e.g. by having an input end of input ends **1301a, 1301b, 1301c,** and **1301d** of each of the optical fibers **1300a, 1300b, 1300c,** and **1300d** connecting to the outputs of their respective light source **1200a, 1200b, 1200c** or **1200d.** For example, optical fiber **1300a** may direct light originating from light source **1200a** etc.

Each of the light sources **1200a-1200d** used, may include at least one light emitting device, configured for emitting light of the same, overlapping or a single wavelength or wavelength band such as: a laser device and/or a light emitting diode (LED). Each optical fiber **1300a, 1300b, 1300c** or **1300d,** may be configured for directing light according to specific properties of the light outputted by the respective light source **1200a, 1200b, 1200c** or **1200d** to which it connects, such as for a specific narrow wavelength band or a specific wavelength, and/or specific light source output power, as well as according to specific gain purposes etc. The optical fibers **1300a-1300d** may each be a doped fiber, optionally having double cladding.

Each optical fiber **1300a, 1300b, 1300c** or **1300d** may be fixedly connected, at its respective output end **1302a, 1302b, 1302c,** or **1302d,** to the input surface **1111A** of the monolithic body **1110** defining thereby respective engagement spots **1101a, 1101b, 1101c** or **1101d,** defined as the volume, area or point of (fixed) engagement between the optical fiber's output end and the input surface **1111A.** Each optical fiber **1300a, 1300b, 1300c** or **1300d** may be fixedly connected to the input surface **111A** of the monolithic body **1110** by way of, for example, splicing, welding, gluing, fusion, and/or via an optical connector or node.

The OE **1120** may be designed and positioned such as to combine the beams exiting the output surface **1111B** of the monolithic body **1110** (herein also "exiting beams") and output a combined beam **1500** that may be a power-scaled beam that maintains the original narrow/single wavelength band of all entering beams.

The OE **1120** may include a phase mask configured for manipulating or shaping beams of light e.g. by inducing localized phase changes. The OE **1120** may include a phase mask **1121** having a phase pattern configured for CBC, e.g. by causing a reverse beam diffraction. One example, for an OE **1120** phase mask **1121** design that can be used for CBC, is one that acts as a reversed beam splitter.

A beam splitter is a diffraction OE that includes a phase mask configured to split a single incident beam into several beams at equal separation angles from one another, the number of beams N resulting from the beam splitting, is defined as the "order" of the beam splitter. Placing a beam splitter OE **1120** in a reversed directionality may be used for beam combining.

According to some examples, the structure of a beam splitter OE **1120** may be made from an optical substrate (usually glass e.g. fused silica glass) over which a periodic phase pattern may be etched. The surface of the phase mask can be reflective or clear and the combining effect of the OE **1120** may be achieved by causing the beams to pass therethrough or reflected therefrom. The phase pattern may be periodic, where the number of beams N inputted into the OE **1120** (which is the splitting order) and/or the separation angle, may determine the design of the periodic pattern of the OE's **1120** phase mask **1121.**

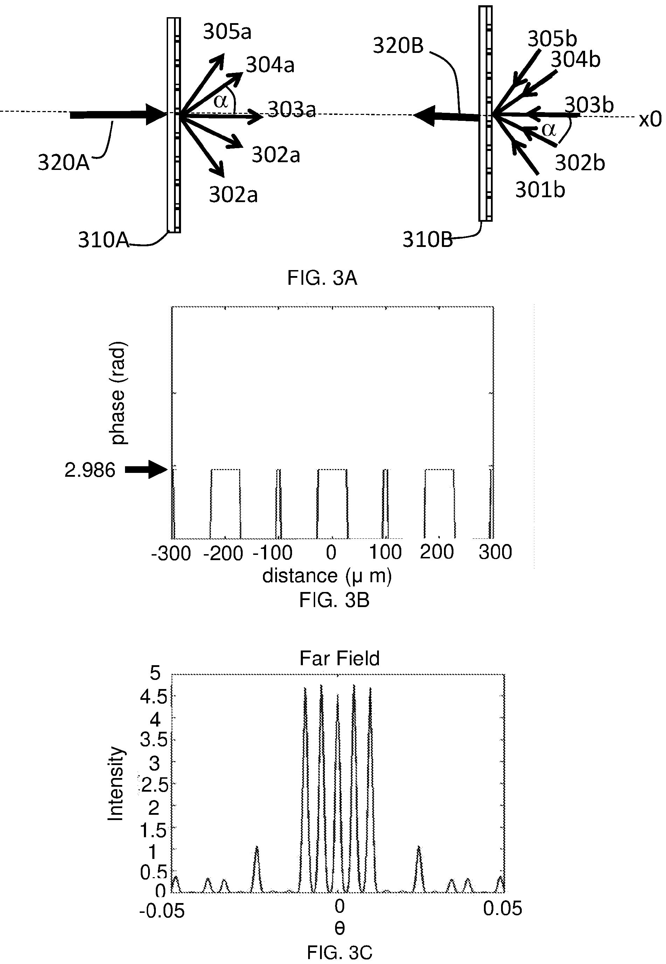

**FIG. 3A** shows an exemplary manner, in which a beam splitter can be reversed for serving as a beam combiner. On the left side, an incoming optical beam **320A** is directed towards a beam splitter **310A,** designed to split the incoming optical beam **320A** into multiple output optical beams **301a, 302a, 303a, 304a** and **305a.** The output optical beams **301a, 302a, 303a, 304a** and **305a** are separated from one another at equal separation angles $\alpha$ (alpha). Using a beam splitter element **310B** having the same phase mask pattern and design as the beam splitter **310A** and inputting multiple input beams **301b, 302b, 303b, 304b** and **305b** spaced in the same separation angle $\alpha$ (alpha) and having beam properties such as wavelength as the output beams $\alpha$ (alpha), the beam splitter element **310B** will combine the input beams **301b, 302b, 303b, 304b** and **305b** into a single combined output beam **320B,** which may maintain the same wavelength(s) of the incoming input beams **301b, 302b, 303b, 304b** and **305b.**

**FIG. 3B** shows an exemplary diagram for a beam splitter phase mask cross sectional pattern. The relative thicknesses and depts of the etchings create over one of the sides of the OE includes a repetitive phase mask which determines how the beam will diffract when exiting the mask. In this case it will split into 5 main beams, and several high order beams- side lobes, that can be seen on **FIG. 3C.** The efficiency of the OE may be determined by the power in the main orders divided by the total power. The separation angle between the output beams (the peaks in the graph) may be determined by the properties of the period in the phase mask (e.g. spacing between peaks). In this example the period length is 200 ⁇ m (micrometer) and the resultant separation angle is 0.005 Rad. Decreasing the period length will increase the separation angle and vice versa.

In coherent beam combining, the beam splitter OE may be reversed by combining N beams separated in equal separation angles into a single combined output beam. The effect can be achieved by reversing the effect of the diffraction OE and replicating the N beams in the exact separation angles that correspond to the specific OE phase mask design only in reverse directions so that they are incident on the OE instead of emerging out of it (as illustrated in **FIG. 3A**).

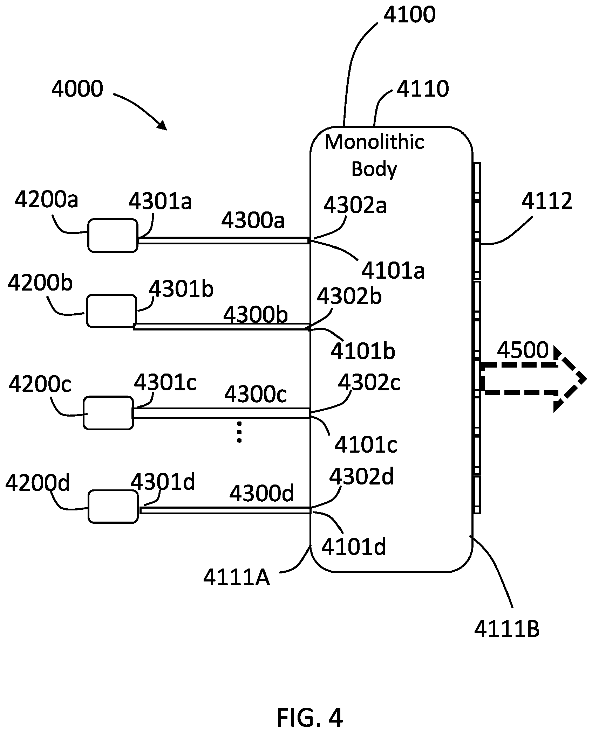

**FIG. 4** shows a general layout of a CBC system **4000** for combining multiple optical beams, according to some examples, which do not fall under the scope of the claims. The CBC system **4000** may include: multiple light sources such as light sources **4200a, 4200b, 4200c** and **4200d**; multiple optical fibers such as optical fibers **4300a, 4300b, 4300c** and **4300d**; and a beam combining device **4100** that includes a monolithic body **4110** having a phase mask **4112** embedded or integrally connected to an output surface **4111B** thereof.

According to some examples, each optical fiber **4300a, 4300b, 4300c** or **4300d** may direct light originating from a respective light source **4200a, 4200b, 4200c** or **4200d** e.g. by having an input end of input ends **4301a, 4301b, 4301c,** and **4301d** of each of the optical fibers **4300a, 4300b, 4300c,** and **4300d** connecting to the outputs of their respective light source **4200a, 4200b, 4200c** or **4200d**. For example, optical fiber **4300a** may direct light originating from light source **4200a** etc.

Each of the light sources **4200a-4200d** used, may include at least one light emitting device, configured for emitting light of the same, overlapping or a single wavelength or wavelength band such as: a laser device and/or a light emitting diode (LED). Each optical fiber **4300a, 4300b, 4300c** or **4300d**, may be configured for directing light according to specific properties of the light outputted by the respective light source **4200a/4200b/4200c/4200d** to which it connects, such as for a specific narrow wavelength band or a specific wavelength, and/or specific light source output power, as well as according to specific gain purposes etc. The optical fibers **4300a-4300d** may each be a doped fiber, optionally having double cladding.

Each optical fiber **4300a, 4300b, 4300c** or **4300d** may be fixedly connected, at its respective output end **4302a, 4302b, 4302c,** or **4302d,** to the input surface **4111A** of the monolithic body **4110** defining thereby respective engagement spots **4101a, 4101b, 4101c** or **4101d,** defined as the volume, area or point of (fixed) engagement between the optical fiber's output end and the input surface **4111A**. Each optical fiber **4300a, 4300b, 4300c** or **4300d** may be fixedly connected to the input surface **4111A** of the monolithic body **4110** by way of, for example, splicing, welding, gluing, fusion, and/or via an optical connector or node.

According to some examples, the optical fibers **4300a, 4300b, 4300c** and **4300d** may be connected to the output surface **4111B** of the monolithic body **4110** e.g. by way of slicing, fusion, welding adhering etc. and may be an integral part of the beam combining device **4100.**

According to some examples, the monolithic body 4110 may be configured to direct the entering beams, entering therein via its input surface **4111A** towards the output surface **4111B** such that the exiting beams reach the phase mask **4112** at an equal and specific exit separation angle corresponding to the design of the phase mask and optionally also at a specific exit angle in respect to a main axis.

According to some examples, the phase mask **4112** may be engraved, etched or embossed over the output surface **4111B** of the monolithic body **4110** and may be designed for CBC.

For example, the phase mask **4112** may be designed as a phase mask e.g. a diffraction grating mask for combining the exiting beams, passed through the phase mask **4112,** into a single coherent output combined beam **4500** of a scaled-up power and high output beam quality.

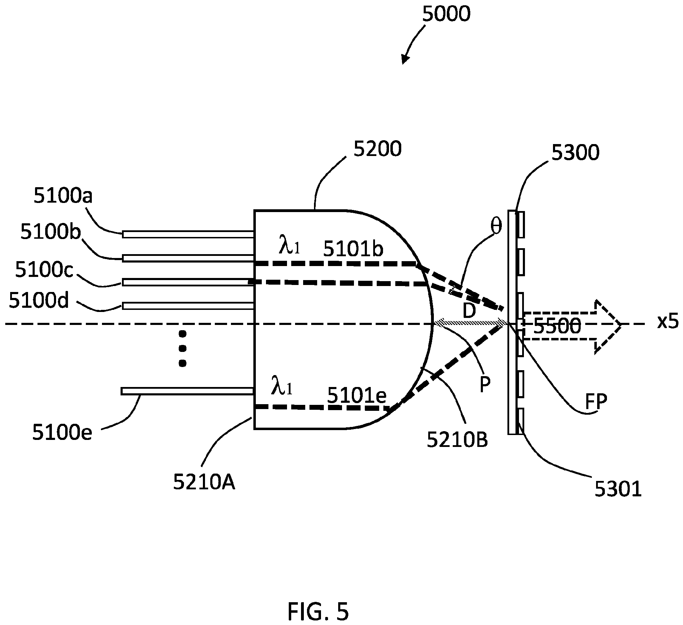

Reference is made to **FIG. 5** showing a beam combining device **5000** having a monolithic body **5200** with a collimator design and a separate and external OE **5300** having a phase mask embedded therein, according to some examples, which do not fall under the scope of the claims. The beam combing device **5000** may also include a multiplicity of optical fibers such as optical fibers **5100a, 5100b, 5100c, 5100d** and **5100e** fixedly connected, at output ends thereof, to a flattened input surface **5210A** of the monolithic body **5200**.

Each of the optical fibers **5100a, 5100b, 5100c** and **5100d** may be configured to guide light originating from one or more light sources and output the guided light from output ends thereof, which connect to the input surface **5210A** of the monolithic body **5200**. The beams outputted from the output ends of the optical fibers **5100a, 5100b, 5100c** and **5100d** may be set to enter the monolithic body **5200** (and therefore are referred to as the "entering beams"), from the flattened or straight input surface **5210A** thereof, at equal spacing and equal separation angles, which in this configuration is a zero angle, in respect to a main axis **x5** as they are parallel to one another.

The monolithic body **5200** may be fully transparent and may have an output surface **5210B** that is curved to form a lens like collimator design for collimating the entering beams, entering at a zero entrance angle in respect to the main axis **x5,** into a focal point **FP,** located over the main axis **x5** and in a focal plane that is substantially perpendicular to the main axis **x5** and distant from it at distance **D,** where **D** is defined as the focal distance. The OE **5300** may be located over that focal plane and the focal distance **D** from the collimation peak **P** of the output surface **5210B** of the monolithic body **5200** where **D** may be defined as the focal length. As seen in **FIG. 5,** the flattened input surface **5210A** may also be perpendicular to the main axis **x5** for enabling the entering beams to enter in parallel to one another and to the main axis **x5.**

The OE **5300** may include a phase mask **5301** e.g. etched, embossed or adhered thereto, configured to combine exiting beams, that exit the output surface **5210B** of the monolithic body **5200** for outputting a combined output beam **5500,** optionally directed along the main axis **x5**.

The OE **5300** may be a diffraction grating such as a beam splitter having an etched, embossed or adhered phase mask corresponding to entering and/or exiting beams properties such as wavelength, phase, intensity etc. as well as to the design, dimensions and/or properties of the collimator monolithic body such as focusing properties, focal length etc. The phase mask design may also depend on the separation angles θ (theta) of the optical beams exiting and/or entering the monolithic body **5200** from the output and/or input surfaces **5210B/5210A** thereof.

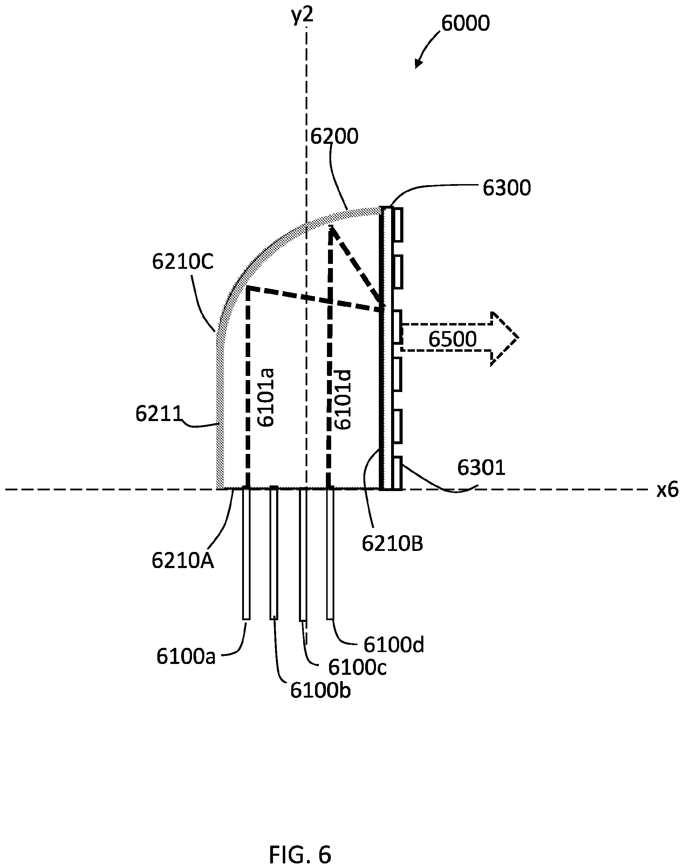

Reference is now made to **FIG. 6,** showing a beam combining device **6000** having multiple optical fibers **6100a, 6100b, 6100c** and **6100d** (connectable to one or more light sources for outputting coherent entering beams); and a monolithic body **6200** with three surfaces, according to other examples, which do not fall under the scope of the claims.

The monolithic body **6200** may have three surfaces: a flattened input surface **6210A** fixedly connectable to the optical fibers **6100a, 6100b, 6100c** and **6100d;** a flattened output surface **6210B** having a phase mask **6301** embedded therein or connecting thereto via an OE **6300,** and an additional third surface **6210C,** located between the input surface **6210A** and the output surface **6210B.**

The third surface **6210C** may be curved and reflective e.g. by having a reflective layer **6211** coated or attached at an inner or outer side thereof, for directing the entering beams parallelly entering the monolithic body **6200** from the input surface **6210A** thereof, towards the output surface **6210B** by way of reflecting the entering beams such that the separation angles between each adjacent exiting beams will match the design and positioning of the phase mask **6301** of the OE **6300.**

According to some examples, the phase mask **6301** of the OE **6300** may include a diffraction grating phase mask or any other mask profile design that enables combining the exiting beams into a coherent power scaled combined output optical beam **6500.**

The geometry of the monolithic body **6200** and the relative positioning of its input surface **6210A,** third surface **6210C** and output surface **6210B** and the curving shape of the third surface **6210C** may be such that entering beams such as beams **6101a** or **6101d,** respectively emanating from optical fibers **6100a** and **6100d,** entering from the input surface **6210A** are converged/focused into a focal point located at the output surface **6210B,** where the phase mask **6301** is also located.

According to some examples, the input surface **6210A** may be flattened defining an axis x6 to which the flattened output surface **6210B** may be perpendicular (i.e. the input surface **6210A** being perpendicular to the output surface **6210** and may be engaging therewith through an engagement axis also perpendicular to axis **x6**), where the curving of the (reflective) third surface **6210C** and the design and positioning of the phase mask **6301** may be such that the combined output optical beam **6500** is outputted in parallel to the **x6** axis direction.

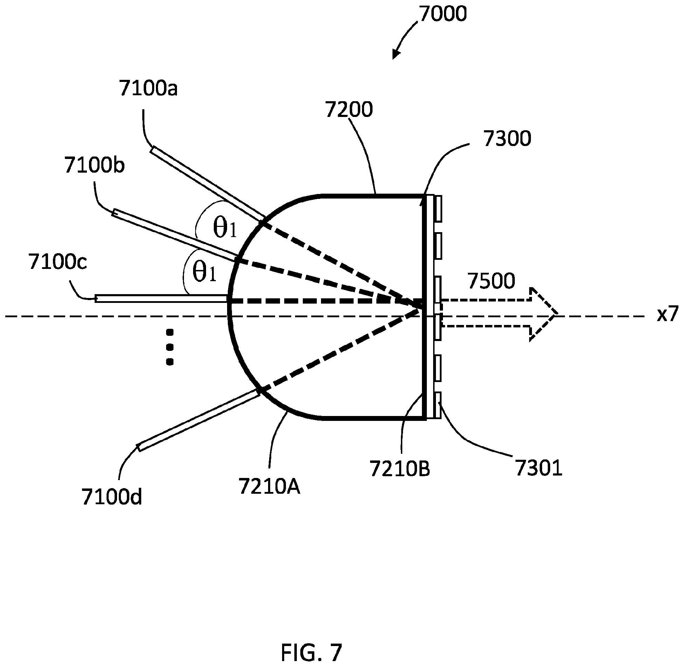

Reference is now made to **FIG. 7,** showing a beam combining device **7000** having multiple optical fibers **7100a, 7100b, 7100c** and **7100d** (connectable to one or more light sources for outputting coherent entering beams); and a semi-sphered or lens-shaped monolithic body **7200** having a curved input surface **7210A** and a flattened output surface **7210B.**

The output surface **7210B** of the monolithic body **7200** may be integrally connected to an OE **7300** or having a phase mask **7301** embedded thereover such that the exiting beams reach the output surface **7210B** at a specific equal exit separation angle θ1 (theta 1), which should match the design of the phase mask **7301.** The specific value of an exit separation angle equal for all exiting beams may be achieved by having the optical fibers **7100a, 7100b, 7100c** and **7100d** connect to the curved input surface **7210A** at equal spacings from one another and optionally configuring the curved input surface **7210A** such that it has a spherical or semispherical symmetry about a main axis **x7,** so that the entry separation angle θ1 (theta 1) between the entering beams is the same for all entering beams and/or focusing all entering beams into a single focal point located over the main axis **x7.** In this configuration, the light outputted by the optical fibers **7100a, 7100b, 7100c** and **7100d** is angularly directed towards the flattened output surface **7210B** to focus the entering beams into a single focal point located over the output surface **7210B** located over the main axis **x7.** The main axis **x7** may be defined as an axis that is perpendicular to the output surface **7210B.**

According to some examples, the phase mask **7301** may be designed and positioned such as to combine all exiting beams into a single combined output beam **7500** that may be propagating along the main axis **x7.**

Another way in which the entering beams can be collimated or focused may be achieved by using a monolithic body having varying refractive indices, such as, for example, by using a monolithic body with graded indexing (GRIN) where the gradually changing of the refractive index may create a focusing or a directing effect over the entering beams.

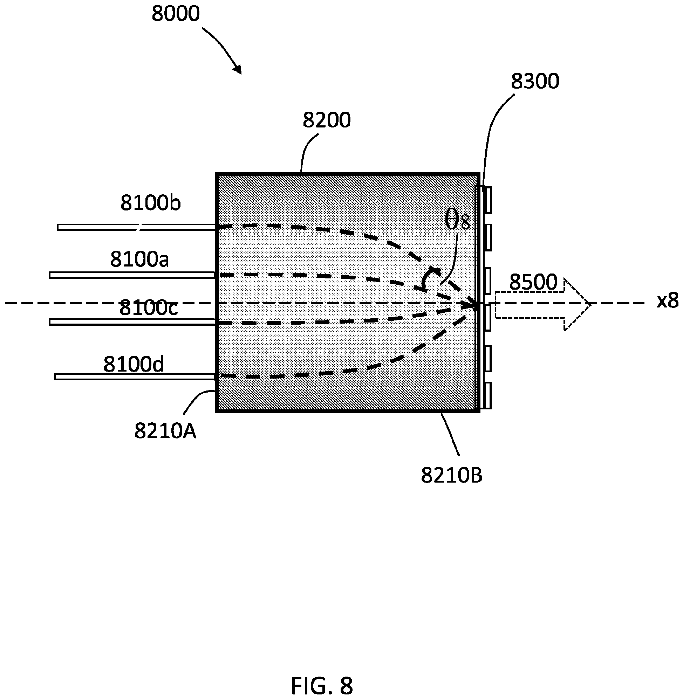

FIG. 8 shows a beam combining device **8000** that includes: a plurality of optical fibers **8100a, 8100b, 8100c** and **8100d;** a monolithic body **8200** having a gradually varying refractive indexing configuration; and a separate phase mask **8300.**

According to some examples, the monolithic body **8200** may include a gradual variation of the refractive index in the monolithic body **8200** that can create a lens-like focusing effect, for focusing the entering beams into a single focal point. For example, the monolithic body **8200** may have a cylindrical shape and be designed such that the outer cylindrical areas of the monolithic body **8200** may have lower refraction indices (indicated in darker gray color) than the inner areas (indicated in lighter gray to white coloring), such that the refractive index is gradually changed (i.e. gradually increased or reduced) towards the central cylinder axis **x8** or a central plain including the axis **x8,** which may also be the main axis.

The monolithic body **8200** may have a flattened input surface **8210A** allowing the light from the optical fibers **8100a, 8100b, 8100c** and **8100d** to enter in parallel direction to one another and in relation to the main axis **x8;** and an output surface **8210B** which may also be flattened and parallel to the input surface **8210A** i.e. also perpendicular to the main axis **x8,** allowing thereby easier splicing of the optical fibers **8100a, 8100b, 8100c** and **8100d** to the input surface **8210A** and attaching, etching or embossing of the phase mask **8300** onto the output surface **8210B** of the monolithic body **8200.**

According to some examples, as shown in **FIG.8,** the phase mask **8300** may be implemented as a diffraction grating mask etched or embossed over the output surface **8210B** in case the focal point is located over the output surface **8210B.**

Alternatively, the phase mask **8300** may be implemented as a separate diffraction optical element (DOE) attached to the output surface **8210B** in case the focal point of the entering beams is located over the output surface **8210B** or externally located therefrom, in case the focal point is located externally from the monolithic body **8200.**

The phase mask **8300** may be positioned in parallel to the input and output surfaces **8210A** and **8210B** and (therefore) perpendicularly to the main axis **x8,** ultimately for having the exit beams focused at a plane over which the phase mask **8300** is located, at equal and specific separation angles θ8 (theta 8), corresponding to the mask profile design, for allowing combining the exiting beams into a single coherent combined output beam **8500,** optionally propagating along the main axis **x8.**

The gradually varying refractive indexing configuration of the monolithic body described in **FIG. 8** illustrates examples in which the beams passed through the monolithic body, converge into a focal point or area, due to the indexing changes, that is located over the OE's phase mask, which is external to the monolithic body. Other configurations may be such that the curving of the beams passed through the monolithic body converge them to a focal point or area that is located over the phase mask which may be coupled to or positioned over the output surface of the monolithic body.

Embodiments and examples or components of embodiments and examples of the systems and methods described herein, such as the monolithic bodies **1110, 4110, 5200, 6200, 7200, 8200** and/or OEs **1120, 5300, 7300**and/or phase masks **1121, 4112, 5301, 6301, 7301, 8300,** may be shown in the drawings in two-dimensions (2D) configuration, while referring to components that may be of 3D, for illustration purposes only.

Embodiments and examples provided herein may also include systems using multiple coherent beam combining devices (also referred to herein as CBC devices) in a network configuration such as to provide enhanced power scaling by using additive optical signal amplification, e.g. by using one or more additional CBC devices and/or spectral beam combining (SBC) devices.

For example, such a system may include a first set of CBC devices, each using multiple optical waveguides such as optical fibers fixedly connected to its respective input surface and each outputting an amplified coherent and combined output optical beam. The combined output optical beam of each CBC device may then be guided/directed as an entering optical beam towards another beam combining device such as a CBC or SBC device through its respective input surface, where the additional beam combining device may be configured to cause another amplification of all the coherent combined beams from several other such beam combining devices. The guiding or directing of the coherent and combined output optical beams may be done using optical waveguides connecting to the output surface of each of the CBC devices or by positioning the additional beam combining device such that the optical beams reach its input surface through the air (unguided).

The configuration may be repeated by having multiple CBC devices' output beams used as input beams of other one or more CBC device having the same or different configuration, such as to form any kind of CBC devices network (herein "reticulated CBC system"), depending on CBC devices' material properties limitations (e.g. maintaining rigidity in high temperatures caused due to high power beams directed thereby) and losses that may be formed.

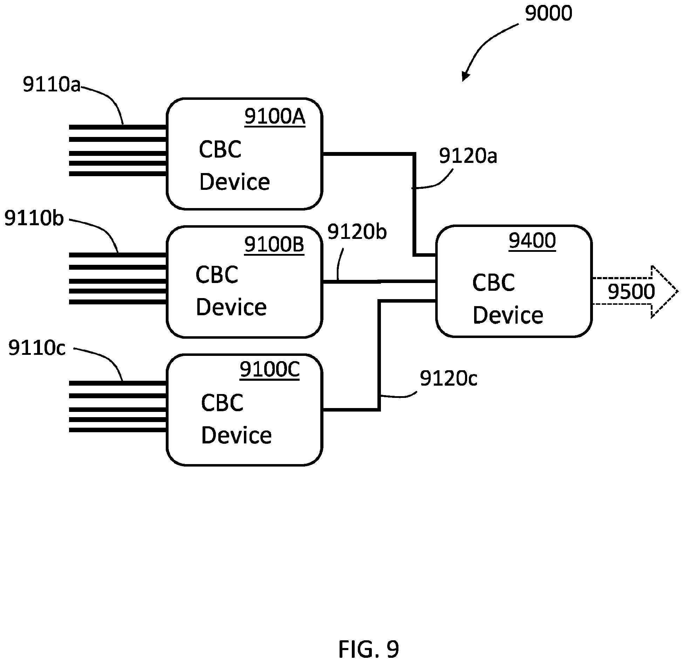

**FIG. 9** shows a CBC system **9000** by reticulating multiple beam combining devices, according to some examples, which do not fall under the scope of the claims. The CBC system **9000** includes multiple input CBC devices such as input CBC devices **9100A, 9100B** and **9100C;** and an additional CBC device **9400.** According to some examples, each of the input CBC devices **9100A, 9100B** and **9100C** has and/or fixedly connects to a set of multiple input optical fibers such as fiber sets **9110a, 9110b** and **9110c,** respectively and outputs a coherent, combined output beam that may be guided via its respective optical waveguide **9120a, 9120b** and **9120c** towards an input surface of the additional CBC device **9400.**

Each of the CBC devices **9100A, 9100B** and **9100C** may include a monolithic body and a phase mask, according to one of the configurations described above. The monolithic body of each of the CBC devices **9100A, 9100B** and **9100C** may be configured to focus the entering beams, emanating from the optical fibers of the respective CBC device, to a focal point located over a focal plane, over which the phase mask is located. The phase mask may be located over an output surface of the respective monolithic body (e.g. in which case the output surface may have the phase mask etched, embossed or attached/coupled thereto and may be therefore flattened), or located externally from the monolithic body (in which case - the phase mask may be implemented in a separate OE such as a DOE).

The CBC devices **9100A, 9100B** and **9100C** may be similar, identical or different in configuration from one another, e.g. in type, chemical composition, wavelength and/or number of entering beams, size, geometry, number and/or configuration of optical fibers connected thereto etc., depending on system requirements.

Each of the optical waveguides **9120a, 9120b** and **9120c** may be designed and positioned in respect to the output surface of the monolithic body of its respective CBC device, such as to be able to sustain the high output power of the combined output beam and guide thereof therethrough in a coherent and collimated manner for avoiding losses in power and/or coherency. The additional CBC device **9400** may be configured to focus the entering beams emanating from the waveguides **9120a, 9120b** and **9120c** and combine thereof by having a monolithic body configured to focus the entering beams into a focal point located over a focal plane, and using a phase mask (not shown), located over the focal plane, for causing a CBC of the entering beams, outputting a coherent final output beam **9500** that may be significantly additively amplified.

Examples of the reticulated CBC system may be designed to any branching/network configuration, e.g. using multiple additional CBC devices, where the output beams thereof serve as the entering beams to yet additional CBC devices.

The phase mask of one or more of the above-described examples may be configured as a diffractive grating mask such as a beam splitter used in a reversed manner for beam combining. The diffractive grating mask may be implemented as an etching or embossment over a surface (e.g. the output surface of the monolithic body of the beam combining device or over a surface of a separate element). According to some examples, the diffraction grating phase mask may be implemented as an immersed diffraction grating mask (e.g. by having the grating immersed in a material of a higher refraction index) for having also the external side of the phase mask flattened and/or for improving output beam quality. A flat and planar output surface of the phase mask may be required, for instance, for allowing use thereof for CBC devices of the reticulated CBC systems, for example, for allowing fixedly attaching the waveguides thereof to a flat output surface of the phase mask of the CBC devices.

According to some examples, the phase mask may be made from a transparent or at least partially transparent material.

Spectral beam combining (SBC) may be used for power scaling of fiber lasers to extremely high output powers, e.g., more than 2000 watts of output power, by combining laser beams of different wavelengths and requiring modest bandwidth and wavelength control of the individual sources.

The general principle of SBC is to combine several entering beams of non-overlapping optical spectra using some kind of wavelength-sensitive beam combiner. such as a prism or an optical diffraction grating element, which can deflect incident beams according to their wavelengths.

Combining multiple beams of non-overlapping spectra may be done by directing all beams onto a phase mask such as an optical grating, each beam being directed towards the phase mask at a slightly different angle so that all beams exit the phase mask in the same angle.

Assuming each beam is monochromatic, its ideal relative angle to the optical grating plane (ideal beam combining) may be related to its respective wavelength according to the following mathematical relation:

$$\theta_i \propto g\lambda_i \ (1)$$

Where g represents the grating density and $\lambda_i$ represents the wavelength of the respective incident beam.

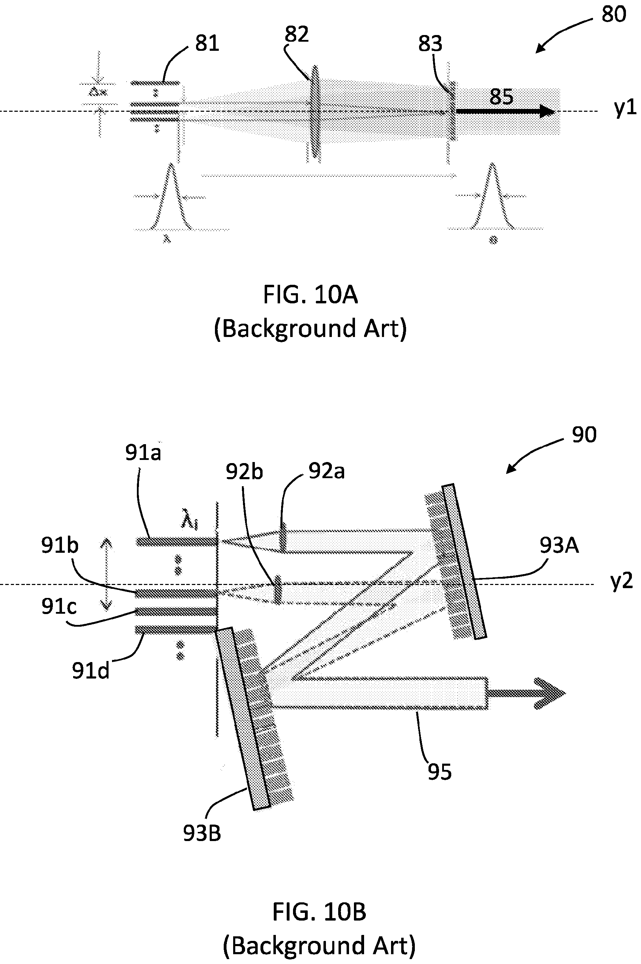

**FIG. 10A** (Background Art) is a schematic illustration of an SBC optical setup **80** based on a single-diffraction scheme. The SBC optical setup **80** includes a linear array of lasers outputting parallel optical beams **81,** a focusing lens **82,** and a diffraction grating optical element **83.**

As shown in **FIG. 10A,** the parallel entering optical beams **81** are directed to the focusing lens **-82,** where the focusing lens **82** focuses and directs the beams to diffraction grating optical element **83,** which diffracts the beams into a common exit angle and multiplexes the beams into a single combined output optical beam **85.** In this configuration, since each beam is of a different wavelength and due to the focusing of the entering optical beams **81,** each optical beams impinges the diffraction grating optical element **83** at a different angle allowing the diffraction grating optical element **83** to divert each beam towards the same output direction (along axis **y0**). Since all elements of the optical setup **80** are spaced from one another, maintaining alignment and stability is difficult especially for a long period of time.

In practice, the ability to combine a large number of optical beams covering a broad wavelength band and maintain a high-quality beam is also limited when using such an optical setup **80** as shown in **FIG. 10A.** The need to impinge the diffraction grating optical element **83** at different angles, i.e., a different angle for each laser wavelength, allows the use of a common focusing lens **82** only for specific wavelengths equal intervals between adjacent optical beams. This implies that for a small wavelength interval $\Delta\lambda$ between channels, a small angular interval $\Delta\theta$ is required

so that for a finite fiber pitch the lens focal length could be prohibitive for certain applications.

In addition, in order to avoid non-linear phenomena in a high-power fiber laser, a finite spectral bandwidth $\delta\lambda$ is required, thus, the use of diffraction grating optical element **83** may cause degradation in output optical beam quality according to the following relation:

$$\delta\theta \; \propto \; g\delta\lambda \,(2)$$

where $\delta\theta$ is the angle broadening of the diffracted beam, g is the grating density of lines and $\delta\lambda$ is the wavelength broadening of the respective laser optical beam.

According to equation (2) the divergence of a beam having a finite spectral width $\delta\lambda$ is degrading (broadening of divergence angle) by a factor proportional to that spectral width $\delta\lambda$, where this factor is determined by the optical properties of the respective diffraction grating optical element **83.**

The use of narrow band laser beams (typically less than 10GHz) with a single diffraction grating limits the maximal power of the laser beams mainly due to Stimulated Brillouin Scattering (SBS), when used in fiber laser amplification, characterized by a strong reflection back into the lasers. The SBS setup **80** power threshold is proportional to

$$P_{th} \propto \frac{L*\Delta v}{A}$$

the fiber length (L), the band width ($\Delta v$) and inversely proportional to the core diameter (A): .

Enlarging the core diameter deteriorates the beam quality (higher optical modes are easily excited in fibers having large core diameters), and on the other hand enlarging the bandwidth damages the combined beam divergence; these two parameters limit the total power and quality of the output optical beam.

It should be noted that high power fiber lasers which require a large number of channels may limit the beam quality by a magnitude of $M^2$.

Also, for an efficient SBC, the alignment of the beam position and the angle at which each of the optical gratings is impinged has to be very accurate and must be kept so during the whole procedure.

**FIG. 10B** (background art) is a schematic illustration of a SBC optical setup **90,** which includes: two identical diffraction grating elements (DGEs): a first DGE **93A** and a second DGE **93B;** multiple light sources **91a, 91b, 91c,** and **91d** outputting multiple parallel entering optical beams each having a slightly different wavelength; and multiple focusing lenses (each for every light source) such as lenses **92a** and **92b.**

As shown in **FIG. 10B,** the lenses **92a** and **92b** are positioning such that their respective light source's output point is the focal point of the respective lens, so as to direct a respective optical beam of a substantially maintained equal diameter (with low beam divergence) towards the first DGE **93A.** The beams passed through the lenses, impinge the first DGE **93A** at parallel trajectories to one another and to axis **y2,** and are deflected from the first DGE **93A** at non-parallel trajectories to one another and to axis **y2,** due to the differences in their wavelengths. The optical beams deflected from the first DGE **93A** are directed towards and imping the second DGE **93B,** which combines them by deflecting them towards the same direction in parallel to one another and to axis **y2** for outputting a combined multispectral output optical beam **95.** This configuration requires the two DGEs **93A** and **93B** to be positioned in parallel to one another in angularly in respect to the trajectories of the entering beams and to **y2.**

Aspects of disclosed embodiments pertain to beam combining devices each having a monolithic body configured for SBC of multiple spectrally differentiated optical beams emanating from a plurality of light sources such as from output ends of multiple optical fibers fixedly connected or connectable to the, where the beam combining devices are configured for SBC of the optical beams. The monolithic body may include at least: an input surface, a diffractive surface and an output surface.

According to some embodiments, the monolithic body may be configured to direct the entering optical beams, entering via the input surface of the monolithic body, **through a multi-diffraction optical pathway** inside the monolithic body, e.g. by directing the entering optical beams such as to impinge the diffractive surface at least twice, for combining the entering optical beams into a single combined multispectral combined output optical beam, exiting the monolithic body via the output surface. The multi-diffraction pathway that the entering optical beams are directed through may be enabled, **using a single diffractive surface,** by causing the entering optical beams to be internally reflected by the monolithic body e.g. by using one or more reflective surfaces in the monolithic body or by configuring at least part of the monolithic body for total internal reflection (TIR) or partial internal reflection (PIR).

According to some embodiments, the configuration of the monolithic body e.g. the geometry, dimensions, elements and/or material(s) thereof, may be designed in accordance with the properties and/or positioning of each of the entering optical beams such as the location in which each optical fiber is connected over the input surface (defining the entrance point of the specific entering beam and its entry trajectory), the wavelengths or wavelength bands of the specific entering optical beams etc. The input, output and/or diffractive surfaces of the monolithic body may be planar (flat) for enabling easy connection of the fiber's ends to the input surface (e.g. by splicing, welding, etc.) and for enabling the multi-diffraction optical pathway of the entering optical beams inside the monolithic body. Other embodiments may include curved configuration of one or more of these surfaces.

According to some embodiments the diffractive surface may include one or more phase masks, configured for diffracting each impinging beam e.g. by deflecting thereof according to its respective wavelength. Non-limiting examples for such phase masks may include: diffraction grating masks, prisms, etc. The phase mask(s) may be etched, embossed or attached to the diffractive surface. The phase mask(s) may be embedded in a separate optical element attached to one side of the monolithic body, thereby forming the monolithic surface thereof.

According to some embodiments, each entering optical beam may enter the monolithic body, through the input surface thereof, at the same entrance angle, i.e. in parallel to one another, and may be directed inside the monolithic body towards the phase mask for being deflected thereby through a first deflection. The deflected optical beams will each have a trajectory of a different direction, since they entered parallelly to one another and since they are of different wavelengths. The monolithic body may be configured to have the optical beams, first deflected from phase mask of the diffractive surface, be redirected again towards that same phase mask (e.g. by again deflecting thereof using reflection and/or refraction means embedded inside the monolithic body) so that the returning optical beams (now having different trajectory directions) will be combined into a single output optical beam, since the reflected optical beams now return and impinge the phase mask (again) at different trajectory directions from one another, allowing the phase mask to again deflect each optical beam at an angle that is different from its impinging one, such that after the second diffraction of the beams all optical beams exit the monolithic body (e.g. via the output surface) at the same trajectory angle (i.e. at the same propagation direction) forming the combined output optical beam.

According to some embodiments, the monolithic body may be at least mostly made from a transparent material such as glass, fiberglass etc. and may be of a uniform single refractive index or changing refractive index.

According to some embodiments, the beam combing device may be defined as including the monolithic body as well as the optical fibers fixedly connected thereto.

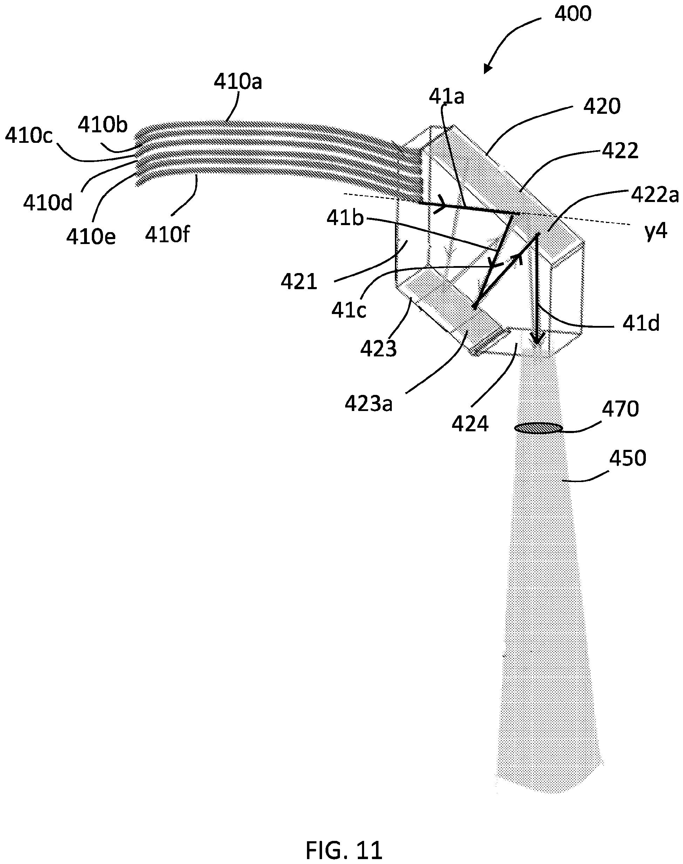

**FIG. 11** is a schematic illustration of an SBC device **400,** according to some embodiments. The SBC device **400** may include: a plurality of optical fibers **410a, 410b, 410c, 410d, 410e** and **410f;** and a monolithic body **420.** The monolithic body **420** may be a single monolithic 3D element or object having: a flat input surface **421** fixedly connected to output ends of the plurality of optical fibers **410a-410f;** a flat diffractive surface **422** having a phase mask **422a** such as a diffraction grating mask etched or embosses thereover, or attached/coupled thereto; a reflective surface **423** being at least partially reflective; and an output surface **424** from which the combined output optical beam **450** exits.

According to some embodiments, the monolithic body **420** may be at least mostly made from a transparent material such as glass, fiberglass etc. and optionally of a uniform single refractive index.

According to some embodiments, to form the reflective surface **423** of the monolithic body **420,** the respective side of the monolithic body **420** may be coated with a reflective material **423a** or attached to a reflective element.

According to some embodiments, as shown in **FIG. 11,** the input surface **421** may be a planar flat surface to which the optical fibers **410a-410f** may be fixedly connected e.g. by welding, splicing and/or gluing, at an output end thereof (outputting the entering optical beams). The connection of the optical fibers **410a-410f** to the input surface **421** may be such that the entering optical beams enter the monolithic body in parallel to one another defining a main axis **y4** (parallel thereto). Optionally, the engagement points of connection between the input surface **421** and the output ends of the optical fibers **410a-410f** may be symmetrically arranged and/or equally spaced. The input surface **421** may be polished for increasing the contact (engagement) area with the output ends of the optical fibers **410a-410f.**

In accordance with some embodiments, the diffractive surface **422** and the reflective surface **423** may both be planar and substantially parallel to each other to enable a double diffraction scheme, in which each of the entering optical beams outputted by the optical fibers **410a-410f** will double impinge the diffractive surface **422,** by having the entering beams (entering in parallel trajectories) directed from the input surface **421** towards the diffractive surface **422,** where they impinge and being deflected each in a different angular direction, from the diffractive surface **422** towards the reflective surface **423;** from the reflective surface **423** towards the diffractive surface **422** (again); and from the diffractive surface **422** towards the output surface **424.** In the final optical path of the optical beams, from the diffractive surface 422 towards the output surface 424, all the optical beams are parallel to one another such as to form the combined output optical beam 450 when exiting the monolithic body 420.

To better illustrate the double-diffraction optical path each beam is passed through, due to the configuration of the monolithic body and in respect to its specific wavelength, one can follow the marked optical path of the entering optical beam **41a** of the optical fiber **410f** (see **FIG. 11):** the optical beam **41a** enters the monolithic body **420** through the input surface **421** thereof at a first angle parallel to the **y4** axis, then impinges the phase mask **422a** of the diffractive surface **422** by which it is deflected to a different trajectory **41b** direction at a non-zero angle in respect to the axis **y4** and directed towards the reflective surface **423** for impinging thereof. The impinging beam of trajectory **41b** is reflected by the reflective surface **423** back towards the diffractive surface **422** along another trajectory **41c** angular to the axis **y4** and then deflected again by the diffractive surface **422** and directed towards the output surface **424** along another trajectory **41d.**

As shown in **FIG. 11,** since all optical beams, emanating from optical fibers **410a-410f,** enter the monolithic body **420** in parallel to one another, the initial trajectories thereof are parallel and directed towards the diffractive surface **422.** However, due to the optical beams' different wavelengths, the angle of the second trajectories of the beams directed towards the reflective surface **423** is different from one beam to another (since the diffraction angle depends on the wavelength of the impinging beam) and therefore the optical beams are also reflected back to the diffractive surface **422** at different trajectories' angles from one another- such that each optical beam reaches the diffractive surface **422** phase mask **422a** again at different trajectory angles from one another. In this way the phase mask **422a** can combine the optical beams by deflecting them again all at the same trajectory angle in respect to axis **y4.** The second diffraction diffract the optical beams at trajectory angles necessary for uniting them into a single output optical beam.

In accordance with some embodiments, the diffractive surface **422** and the reflective surface **423** are parallel to each other and tilted with respect to the input surface **421.**

As shown in **FIG. 11,** the monolithic body **420** may have additional surfaces, which may be flat or curved for having a 3D configuration in which the input, diffractive, reflective and output surfaces form a 3D body in which, for example, the diffractive surface **422** is parallel and opposite to the reflective surface **423** and angular to the input surface **421.**

According to some embodiments, the entering beams outputted by the optical fibers **410a-410f** emanate from a plurality of light sources (not shown) such as from a plurality of input laser devices or LED sources, each configured to output light of a different wavelength.

According to some embodiments, one or more external optical elements may be used, e.g. located in proximity to the output surface, for example a focusing lens **470,** for preventing or decreasing divergence of the output optical beam **450** exiting the monolithic body **420.**

The relation between the beam quality and the double-diffraction design parameters may be expressed as follows:

$$\mathrm{BQ} = 1 + \frac{\Delta x \cdot \Delta \lambda}{2\omega_0 \cdot \delta \lambda} \qquad\qquad (4)$$

Where: BQ is the beam quality of the output combined optical beam, $\Delta x$ is a lateral separation distance between fiber laser sources, $\delta \lambda$ is a typical source spectral bandwidth, $\Delta \lambda$ is a source wavelength separation, and $\omega_0$ is the beam waist (an output beam radius).

As seen in equation (4), the expected beam quality is proportional to $\Delta x$, the lateral separation distance between the entering optical beams' entry points and inversely proportional to the beam waist, $\omega_0$.

Unlike conventional setups where $\Delta x$ and $\omega_0$ are in the order of a few millimeters, the SBC devices disclosed herein, such as SBC device **400,** the spacing between the entry points of the entering optical beams may be in the order of hundreds of microns while the beam waist, $\omega_0$, could be very large ($\Delta x$ could be in the order of 2-5 millimeters) so that corresponding beam waste $\omega_0$ would be at the range 0.5-2milimeters.

Enabling such significant decrease in the spacing between entry points of the entering optical beams can significantly improve the quality of the output optical beam, since the best beam quality ($M^2$) can be achieved when BQ (or $M^2$) =1 ($M^2$=1 is also called a beam with "diffraction limited" divergence). Thus, the beam quality increases as the lateral distance, $\Delta x$, decreases.

According to other embodiments, the entering optical beams may be directed in free space to enter the monolithic body **420** (and not via optical fibers spliced to the input surface **421.** According to some embodiments, fixedly connecting (e.g. splicing) of the optical fibers **410a-410f** to the monolithic body **420** via welding, for instance, directly to a (e.g. glass) input surface **421** may eliminate the need for end caps (ECs) to seal the fiber tips since the light propagation is carried out within the glass. This way drawbacks associated with end caps are eliminated, problems such as back reflections in which light is reflected back from the tips of the end caps back into the optical fiber, causing power losses, therefore the solution provided herein can dramatically reduce losses and increase output power.

Attaching (e.g. splicing) of the optical fibers directly to the input surface can eliminate the need to use endcaps for sealing the fiber tips, thus enabling reduction of the spacing between the optical fibers resulting in a highly compact configuration of the entire SBC device.

It should be noted that tight arrangement of the fibers is highly desirable since the beam quality increases as the fiber tip separation decreases - the beam quality of a SBC scheme based on a given diffractive grating is determined by fiber tip separation, i.e., the smaller the fiber tip separation gets, the better the beam quality becomes. This may be understood when examining equation (5) which relates the focal length of the lens used to the different wavelengths.

$$FL= \Delta x/g\Delta\lambda \text{ (5)}$$

were $\Delta x$ is the separation between fiber tips and FL is the focal length.

Since the relative broadening of beam divergence is proportional to FL: $\delta\theta/\theta \propto FL \times g\delta\lambda$, as the focal length, FL, decreases, the effect of the laser band width, $\delta\lambda$, becomes less significant. Thus, attaching the fibers directly to the bulk glass surface eliminates the need for a highly precise bulk spliced fiber laser array (a factor of 2 in sensitivity is expected).

The monolithic design of the SBC devices provided herein, using a single 3D monolithic body that integrally or non-integrally connects to the phase mask of the reflective surface and fixedly connects to the optical fibers, may dramatically reduce alignment sensitivity to physical and mechanical influences such as shocks, vibrations, shakings, thermal changes etc.

According to some embodiments the SBC devices discussed herein may be encased or held by a designated and specially designed casings or holders.

In accordance with some embodiments, the SBC devices disclosed herein may be further advantageous for having the following characteristics:

the multiple (e.g. double) optical path scheme enables the use of spectral bandwidth in the nanometer range (as opposed to a single diffraction scheme which limits the spectral bandwidth to a pico-meter range). This enables the use of various light sources and optical fibers without complicated bandwidth control schemes.

the multiple optical path scheme and the fixated connection of the optical fibers to the monolithic body result in a robust, compact and precise SBC of broadband wavelength spectrum e.g. ranging from 1030 to 1080 nm or from 1900 to 2100nm without requiring bandwidth control schemes.

since the optical fibers are fixedly connected to the monolithic body, the potential for misalignment is significantly reduced (optionally by many orders of magnitude). There are essentially no moving elements that could lose their alignment during vibrations and/or environmental changes over time.

the combined output optical beam exiting the monolithic body may have (in some configuration) a relatively large beam diameter, which enables power scaleup of the original entering optical beams (E.g. for fiber laser requirements). For example, the combined output optical beam exiting the monolithic body may be characterized by a spot size that is about 3 to 4 times larger than a spot size of an entering optical beam.

Since thermal degradation and optical damage are related to beam intensity, and beam intensity is inversely proportional to the beam area, fiber lasers, using the SBC techniques described herein, can be upgraded to a higher laser power, e.g. to a laser power that is greater by 10 -15 times from the power used for impinging a diffraction grating facet by a single beam.

Most of the optical damage risks are due to changes in the medium in which the beams are traveling along with high power density. In the monolithic spectral beam combining schemes described herein, the optical beams are maintained in the bulk of the monolithic body throughout the entire combining process and leave the monolithic body in a much larger diameter, thus, reduce the optical damage threat by many orders of magnitude.

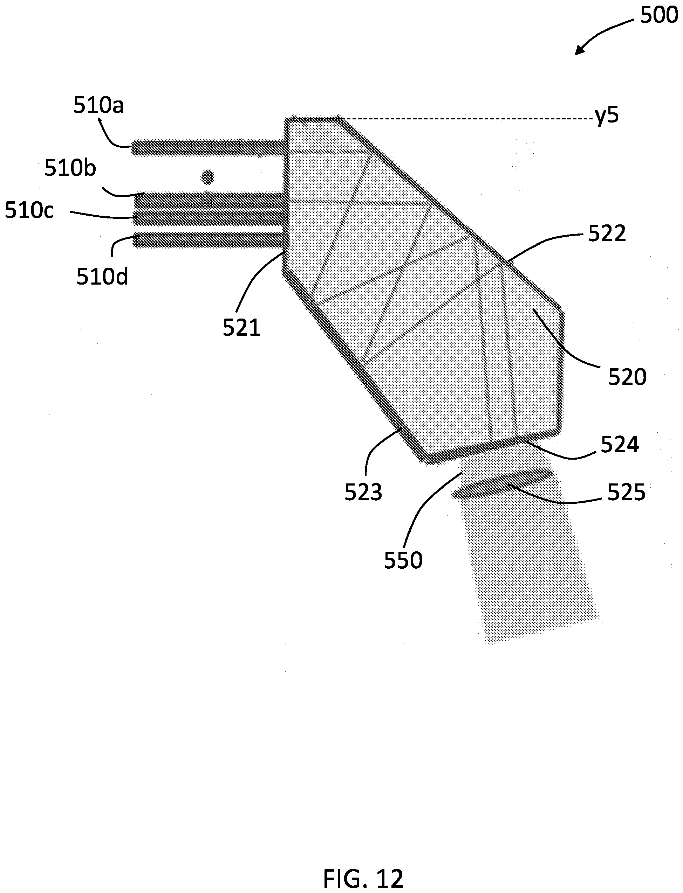

**FIG. 12** shows an SBC device **500** in which the reflective surface and the diffractive surface are not positioned in parallel to one another (i.e. are angular to one another), according to some embodiments. The SBC device **500** includes: a plurality of optical fibers such as optical fibers **510a, 510b, 510c** and **510d;** and a monolithic body **520**. The monolithic body **520** includes an input surface **521,** a diffractive surface **522** having one or more phase masks such as one or more diffraction gratings masks, a reflective surface **523** and an output surface **524**. The monolithic body **520** may include other surfaces for forming the desired angular positioning and/or other geometrical relations between the input, output, diffractive and reflective surfaces **521-524,** in relation to one another.

According to some embodiments, a focusing lens **525** may be used in case the exiting combined output optical beam **550** exits the monolithic body **520** in a diverged manner, for collimating the combined output optical beam **550**. The lens **525** may be positioned externally from the output surface **524**.

According to some embodiments, the entering optical beams enter the monolithic body **520**, via its input surface **521,** in parallel to one another and to an axis **y5,** whereas the other surfaces are angular to axis **y5,** to allow the multi-optical path of each entering optical beam inside the monolithic body. The fixed connection between the monolithic body **520** and the optical fibers **510a-510d** is such as to allow the entering optical beams to enter the monolithic body **520** at parallel entry trajectories.

As shown in **FIG. 12,** the reflective surface **523** in these embodiments, is angular in respect to the diffractive surface **522** as well as to the input and output surfaces **521** and **524.**

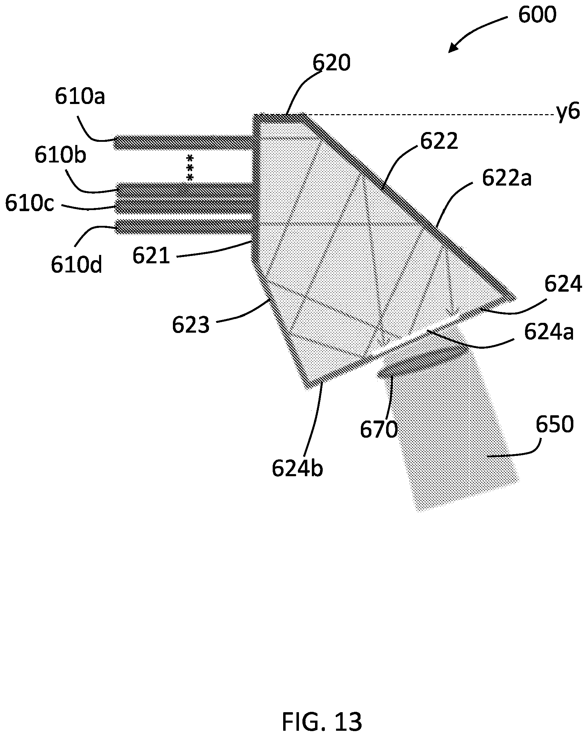

**FIG. 13** shows an SBC device **600** having a multiple internal reflection scheme, according to some embodiments. The SBC device **600** includes: a plurality of optical fibers such as optical fibers **610a, 610b, 610c** and **610d;** and a monolithic body **620.** The monolithic body **620** may include an input surface **621,** a diffractive surface **622** having one or more phase masks such as one or more diffraction gratings phase masks **622a,** a reflective surface **623** and an output surface **624,** which may be partially reflective. The monolithic body **620** may include other surfaces for forming the desired angular positioning and/or other geometrical relations between the input, output, diffractive and reflective surfaces **621-624,** in relation to one another.

According to these embodiments, the output surface **624** includes a transparent area **624a** through which the combined output optical beam **650** may exit the monolithic body **620,** and a reflective area **624b** surrounding the transparent area **624a,** for allowing optical beams inside the monolithic body **620** that impinge the non-transparent surrounding reflective area **624b** to be directed internally back towards the diffractive surface **622** until they reach the right trajectory angle and exit the output surface **624** via its transparent area **624a.**

In these configurations, an optical beam entering from the input surface **621** may be reflected several times by the reflective planes of the reflective surface **623** and/or reflective area **624b,** depending on its entry trajectory angle, its respective wavelength and the angular positioning of the surfaces **521-524** in respect to one another.

The reflective surface **623** and/or the reflective area **624b** of the output surface **624** may be achieved by one of: coating these surfaces/areas with a reflective coating material, attaching reflective element(s) to a transparent surface of the monolithic body **620** over the respective side thereof.

The phase mask(s) **622a** of the monolithic body **620** may be etched, embossed or attached to a side of the monolithic body forming the diffractive surface **622** thereof and may be configured, for example, as a diffraction grating mask.

According to some embodiments, the entering optical beams enter the monolithic body **620,** via its input surface **621** in parallel to one another and to an axis **y6,** whereas the other surfaces may be angular to axis **y6,** to allow the multi-optical path of each entering optical beam inside the monolithic body. The fixed connection between the monolithic body **620** and the optical fibers **610a-610d** is such as to allow the entering optical beams to enter the monolithic body **620** at parallel entry trajectories.

According to some embodiments, the SBC device **600** may include one or more focusing lenses such as focusing lens **670** for collimating the combined output optical beam **650.**

According to other embodiments, the SBC device may include additional reflective surfaces additional to or instead of the reflective and/or the output surface, for allowing total internal reflection (TIR) of beams until they are in the right trajectory angle for exiting the monolithic body.

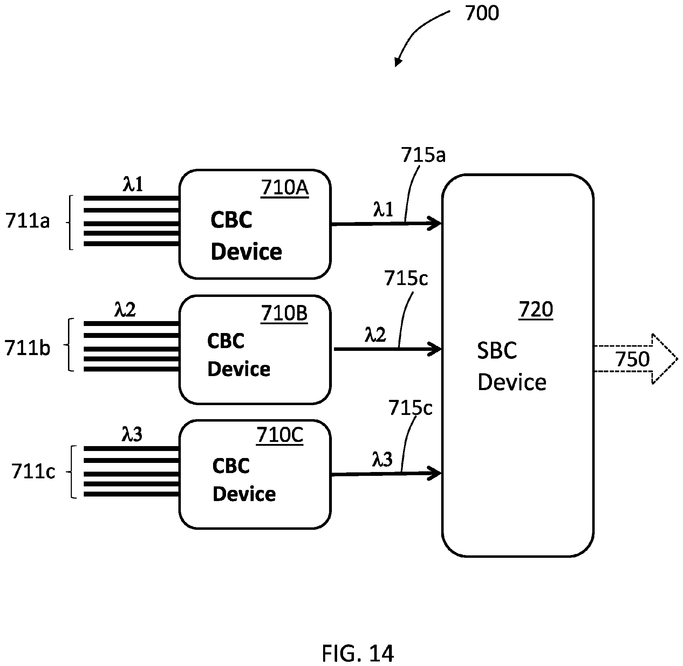

Aspects of disclosed embodiments pertain to systems that integrate coherent and spectral beam combining devices and techniques. For example, a system may include a plurality of CBC devices, each combining multiple coherent and mono-spectral optical beams into a combined coherent mono-spectral output optical beam, where each CBC device is designed to combined and output optical beams of different wavelengths or narrow wavelength bands from one another; and one or more SBC devices, each configured to conduct spectral beam combining of optical beams outputted by the plurality of CBC devices. Reference is made to **FIG. 14,** showing a system **700** for SBC of multiple spectrally differentiated optical beams emanating from a plurality of CBC devices, according to some embodiments and examples.

The system **700** includes a SBC device **720** configured for spectral combining of spectrally differentiated entering optical beams; and multiple CBC devices such as CBC devices **710A, 710B** and **710C,** each being configured to conduct CBC for a plurality of coherent entering optical beams and output combined coherent optical beams such as combined coherent optical beams **715a, 715b** and **715c** of different wavelength, in respect to one another. The SBC device **720** is located and configured such as to spectrally combine all the output optical beams from the multiple CBC devices **710A-710C,** such as to enable optical power scaling of entering optical beams that have already been gone through a previous coherent power scaling, outputting a final spectrally combined output optical beam **750.**

For example, as shown in **FIG. 14,** CBC device **710A** may be configured to combine and output a coherent combined optical beam of a first wavelength λ1, CBC device **710A** may be configured to combine and output a coherent combined optical beam of a second wavelength λ2 and CBC device **710A** may be configured to combine and output a coherent combined optical beam of a third wavelength λ3, where λ1≠ λ2 ≠λ3.

According to some embodiments and examples, for each CBC device **710A/710B/710C** the coherent entering optical beams entering thereto, may emanate from a plurality of sets of optical fibers such as fiber sets **711a, 711b** and **711c,** where each fiber set outputs optical beams of different wavelength and is fixedly connected to the respective CBC device **710a, 710b** and **710c.**

According to some embodiments and examples, the CBC devices **710a, 710b** and **710c** may be configured according to one or more of the CBC devices discussed above, by having each a phase mask and geometry that corresponds to the respective wavelength or wavelength band of the entering optical beams thereof.

According to some embodiments, the SBC device **720** may be configured according to any one of the SBC devices configurations discussed above, using a configuration enabling the double optical pathway for at least twice impinging a diffractive surface thereof, and in accordance with the specific wavelengths of the optical beams outputted by the CBC devices **710a, 710b** and **710c.**

According to some embodiments and examples the combined coherent optical beams **715a-715c** outputted by the CBC devices **710A-710C,** respectively, may be directed towards the SBC device **720,** via optical waveguides such as optical fibers, each being configured to direct optical beams of the respective wavelength and/or intensity of its respective CBC device.

Aspects of disclosed examples, which do not fall under the scope of the claims pertain to methods for coherent beam combining, by using any type of CBC device such as any beam combining device described above, having a monolithic body and a phase mask, where the monolithic body is configured to focus entering optical beams into a focal point over which the phase mask is located, where the phase mask is located over a focal plane including the focal point and being configured to combine the optical beams impinging thereof.

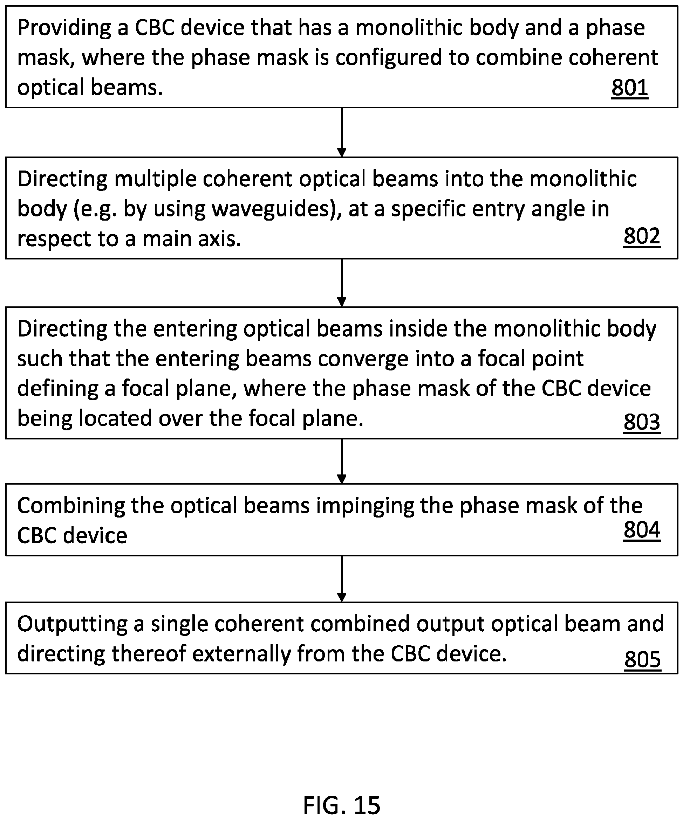

FIG. 15 shows a flowchart, illustrating a CBC process for coherent beam combining, using a CBC device having such monolithic body and phase mask. The CBC process may in some examples include the steps of:

providing a CBC device, having a monolithic body and a phase mask, where the monolithic body may include at least an input and an output surface, and the phase mask may be located and configured such as to coherently combine optical beams directed through the monolithic body (block **801**);

In some examples, the method may further include directing multiple coherent optical beams into the monolithic body at specific entry angles in respect to a main axis (e.g. by using multiple light sources and optical fibers fixedly connecting to the input surface of the monolithic body, as described above in regard to embodiments and examples of the beam combining devices) (block **802**);

In some examples, the method may additionally include directing the entering optical beams inside the monolithic body such that the entering optical beams converge into a focal point, defining a focal plane, where the phase mask may be located over that focal plane (block **803**);

In some examples, the method may further include combining the optical beams impinging the phase mask of the CBC device (block **804**); and

In some examples, the method may also include outputting a single coherent and combined output optical beam and directing thereof externally from the CBC device (block **805).**

Aspects of disclosed embodiments pertain to methods for spectral beam combining of a plurality of spectrally differentiated optical beams, e.g. by using any one of the described above SBC device configuration.

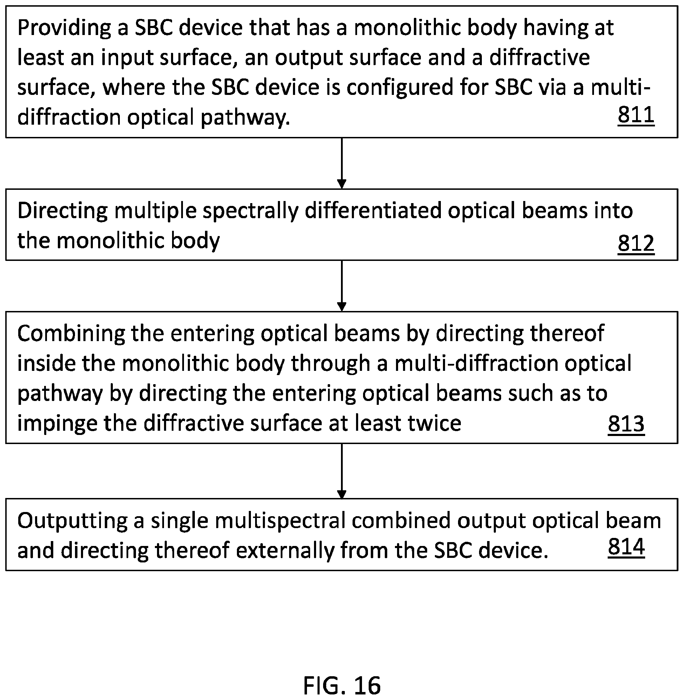

FIG. 16 shows a flowchart illustrating an SBC process which may include the steps of:

Providing a SBC device that has a monolithic body, where the monolithic body may have at least an input surface, an output surface and a diffractive surface and optionally also a reflective surface, the SBC device being configured for SBC through a multi-diffraction optical pathway, e.g. by directing spectrally differentiated entering optical beams, entering therein through the input surface to at least twice imping the diffractive surface (block **811**);

The method may further include directing multiple spectrally differentiated optical beams into the monolithic body e.g. via the input surface of the monolithic body thereof (block **812**);

The method may additionally include combining the entering optical beams by directing thereof inside the monolithic body through a multi-diffraction optical pathway (block **813**); and

The method may also include outputting a single multispectral combined output optical beam and directing thereof externally from the SBC device (block **814**).

Aspects of disclosed embodiments and examples pertain to cascaded beam combing methods for beam combining of a plurality of optical beams emanating from a set of CBC devices, by using at least one additional beam combining CBC or SBC device, depending on the spectral output of the set of CBC devices.

Examples of such cascading implementations can be shown (yet not limited to) in **Figures 9** and **14,** described above.

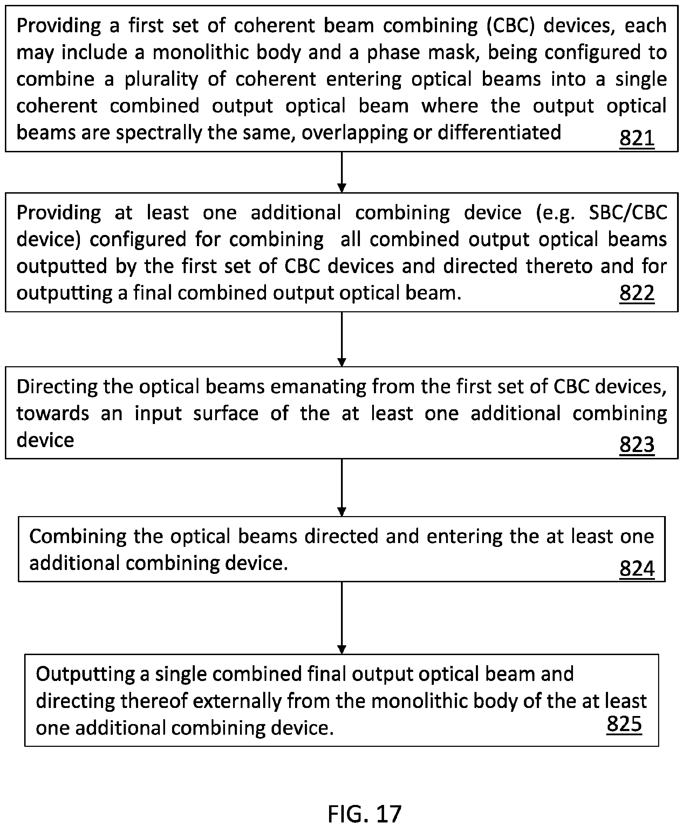

Additionally referring to **FIG. 17,** a cascaded beam combining method may include, according to some embodiments and examples, providing a first set of CBC devices, each being configured to combine a plurality of coherent optical beams entering thereinto and output a coherent combined output optical beam of a specific wavelength or wavelength band, where the combined output optical beams of the CBC devices may be spectrally differentiated, spectrally overlapping or of the same wavelength or wavelength band (block **821).**

In some embodiments and examples, the method may further include providing at least one additional combining device, each being configured for combining the output optical beams emanating from the set of CBC devices, where in examples in which the CBC devices are configured to output combined output optical beams of overlapping or identical wavelengths, the at least one additional combining device may be a CBC device, configured to combined coherent optical beams of the respective wavelength or wavelength band, and in embodiments in which the CBC devices are configured to output spectrally differentiated combined output optical beams, the at least one additional combining device is a SBC device, configured to combined spectrally differentiated optical beams (block **822**);

In some embodiments and examples, the method may additionally include directing the output optical beams, emanating from the first set of CBC devices, towards an input surface of the at least one additional combing device (block **823**); and

In some embodiments and examples, the method may also include combining the optical beams entering the at least one additional combining device (block **824**); and

In some embodiments and examples, the method may further include outputting a single combined final optical beam and directing thereof externally from the at least one additional combining device (block **825**).

The cascading beam combining method may use any kind of networking configuration, in which multiple optical beams emanating from multiple beam combining devices may be combined several times in a cascading manner through multiple additional combining devices.

The first set of CBC devices may fixedly connect to multiple optical fibers for directing therein multiple coherent optical beams for CBC thereof.

According to some embodiments and examples, the directing of the optical beams outputted by the first set of CBC device towards the at least one additional combining device may be carried out by air or via optical waveguides.

While the invention has been described with respect to a limited number of embodiments, these should not be construed as limitations on the scope of the invention, but rather as exemplifications of some of the embodiments.

In the discussion, unless otherwise stated, adjectives such as "substantially" and "about" that modify a condition or relationship characteristic of a feature or features of an embodiment of the invention, are to be understood to mean that the condition or characteristic is defined to within tolerances that are acceptable for operation of the embodiment for an application for which it is intended.

Unless otherwise specified, the terms "substantially", '"about" and/or "close" with respect to a magnitude or a numerical value may imply to be within an inclusive range of -10% to +10% of the respective magnitude or value.

It should be understood, that where the claims or specification refer to "a" or "an" element, component, object, property, characteristic and/or feature, such reference is not to be construed as its being only one of the elements. Hence, reference to "an element" or "at least one element" for instance may also encompass "one or more elements" or "at least one element" etc.

Terms used in the singular shall also include the plural, except where expressly otherwise stated or where the context otherwise requires.

In the description and claims of the present application, each of the verbs, "comprise" "include" and "have", and conjugates thereof, are used to indicate that the object or objects of the verb are not necessarily a complete listing of components, elements or parts of the subject or subjects of the verb.

Unless otherwise stated, the use of the expression "and/or" between the last two members of a list of options for selection indicates that a selection of one or more of the listed options is appropriate and may be made. Further, the use of the expression "and/or" may be used interchangeably with the expressions "at least one of the following", "any one of the following" or "one or more of the following", followed by a listing of the various options.

It is appreciated that certain features of the invention, which are, for clarity, described in the context of separate embodiments or example, may also be provided in combination in a single embodiment. Conversely, various features of the invention, which are, for brevity, described in the context of a single embodiment, example and/or option, may also be provided separately or in any suitable subcombination or as suitable in any other described embodiment, example or option of the invention. Certain features described in the context of various embodiments, examples and/or optional implementation are not to be considered essential features of those embodiments, unless the embodiment, example and/or optional implementation is inoperative without those elements.

It is noted that the terms "in some embodiments", "according to some embodiments", "according to some embodiments of the invention", "for example", "e.g.", "for instance" and "optionally" may herein be used interchangeably.

The number of elements shown in the Figures should by no means be construed as limiting and is for illustrative purposes only.

Throughout this application, various embodiments may be presented in and/or relate to a range format. It should be understood, that the description in range format is merely for convenience and brevity and should not be construed as an inflexible limitation on the scope of the embodiments. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

**Claims**

1. A spectral beam combining (SBC) device (400, 500, 600) for combining a plurality of spectrally differentiated entering optical beams emanating from a plurality of optical fibers (410a-410f, 51a-510d, 610a-610d), **characterized in that** the SBC device (400, 500, 600) comprises at least:

   - a monolithic body (420, 520, 620), which is at least partially transparent and has:
   - an input surface (421, 521, 621), fixedly connected or connectable to the plurality of optical fibers (410a-410f, 51a-510d, 610a-610d);
   - a diffractive surface (422, 522, 622); and
   - an output surface (424, 524, 624),

   wherein the monolithic body (420, 520, 620) is configured to direct the entering optical beams, entering therein via the input surface (421, 521, 621), through a multi-diffraction optical pathway inside the monolithic body (420, 520, 620) by directing the entering optical beams such as to impinge the diffractive surface (422, 522) at least twice, for combining the entering optical beams into a single multispectral combined output optical beam, exiting the monolithic body (420, 520, 620) via its output surface; and
   wherein the monolithic body (420, 520, 620) is further **characterized in that** it is configured to combine the entering optical beams, by directing thereof through the multi-diffraction optical path, such that all optical beams exit the monolithic body (420, 520, 620), via the output surface (424, 524, 624) thereof, in parallel exit trajectories to one another, thereby forming the combined output optical beam.

2. The SBC device (400, 500, 600) of claim 1, wherein the monolithic body (420, 520, 620) further comprises: a reflective surface (423, 523) positioned such as to reflect optical beams at least once, for directing thereof towards the diffractive surface (422, 522, 622); or multiple reflective surfaces (623, 624b) configured for total internal reflection (TIR) or for partial internal reflection (PIR).

3. The SBC device (600) of any one or more of the claims 1 to 2, wherein the output surface is **characterized by** having a reflective area (624b) and a transparent area (624a), positioned such as to reflect optical beams impinging over the reflective area (624b) back into the monolithic body (620) for being re-directed towards the diffractive surface (622), and to allow optical beams directed to the transparent area (624a) to exit the monolithic body (620) therefrom.

4. The SBC device (400, 500, 600) of any one or more of claims 1 to 3, wherein the entering optical beams are of different wavelengths or wavelength bands thereby spectrally differentiated from one another, and wherein the diffractive surface of the monolithic body (420, 520, 620) is **characterized in that** it is designed in accordance with the differences between the wavelengths of the entering optical beams.

5. The SBC device (400, 500, 600) of any one or more of claims 1 to 4, wherein the diffractive surface (422, 522, 622) comprises a diffraction grating mask.

**Patentansprüche**

1. Spektralstrahlkombinierende (SBC) Vorrichtung (400, 500, 600) zum Kombinieren einer Vielzahl von spektral differenzierten eintretenden optischen Strahlen, die von einer Vielzahl von optischen Fasern (410a-410f, 51a-510d, 610a-610d) ausgehen, **dadurch gekennzeichnet, dass** die SBC-Vorrichtung (400, 500, 600) zumindest aufweist:

- einen monolithischen Körper (420, 520, 620), der zumindest teilweise transparent ist und folgendes aufweist:
- eine Eingangsfläche (421, 521, 621), die fest mit der Vielzahl von optischen Fasern (410a-410f, 51a-510d, 610a-610d) verbunden oder verbindbar ist;
- eine diffraktive Fläche (422, 522, 622); und
- eine Ausgangsfläche (424, 524, 624),

wobei der monolithische Körper (420, 520, 620) dazu ausgebildet ist, die eintretenden optischen Strahlen, die in diesen über die Eingangsfläche (421, 521, 621) eintreten, durch einen mehrfach-diffraktiven optischen Pfad innerhalb des monolithischen Körpers (420, 520, 620) zu führen, indem die eintretenden optischen Strahlen so geführt werden, dass sie zumindest zweimal auf die diffraktive Fläche (422, 522) treffen, um die eintretenden optischen Strahlen zu einem einzigen multispektralen kombinierten optischen Ausgangsstrahl zu kombinieren, der den monolithischen Körper (420, 520, 620) über seine Ausgangsfläche verlässt; und

wobei der monolithische Körper (420, 520, 620) ferner **dadurch gekennzeichnet ist, dass** er dazu ausgebildet ist, die eintretenden optischen Strahlen zu kombinieren, indem er sie durch den mehrfach-diffraktiven optischen Pfad führt, so dass alle optischen Strahlen den monolithischen Körper (420, 520, 620) über seine Ausgangsfläche (424, 524, 624) in parallelen Austrittsbahnen zueinander verlassen, wodurch der kombinierte optische Ausgangsstrahl gebildet wird.

2. SBC-Vorrichtung (400, 500, 600) nach Anspruch 1, wobei der monolithische Körper (420, 520, 620) ferner aufweist: eine reflektierende Fläche (423, 523), die so angeordnet ist, dass sie optische Strahlen mindestens einmal reflektiert, um sie auf die diffraktive Fläche (422, 522, 622) zu führen; oder mehrere reflektierende Flächen (623, 624b), die zur internen Totalreflexion (TIR) oder zur internen Teilreflexion (PIR) ausgebildet sind.

3. SBC-Vorrichtung (600) nach einem oder mehreren der Ansprüche 1 bis 2, wobei die Ausgangsfläche **dadurch gekennzeichnet ist, dass** sie einen reflektierenden Bereich (624b) und einen transparenten Bereich (624a) aufweist, die so angeordnet sind, dass sie optische Strahlen, die auf den reflektierenden Bereich (624b) auftreffen, zurück in den monolithischen Körper (620) reflektieren, um sie in Richtung der diffraktiven Fläche (622) umzulenken, und es optischen Strahlen, die auf den transparenten Bereich (624a) gerichtet sind, zu ermöglichen, den monolithischen Körper (620) von dort zu verlassen.

4. SBC-Vorrichtung (400, 500, 600) nach einem oder mehreren der Ansprüche 1 bis 3, wobei die eintretenden optischen Strahlen aus unterschiedlichen Wellenlängen oder Wellenlängenbändern sind und sich dadurch spektral voneinander unterscheiden, und wobei die diffraktive Fläche des monolithischen Körpers (420, 520, 620) **dadurch gekennzeichnet ist, dass** sie gemäß den Unterschieden zwischen den Wellenlängen der eintretenden optischen Strahlen konstruiert ist.

5. SBC-Vorrichtung (400, 500, 600) nach einem oder mehreren der Ansprüche 1 bis 4, wobei die diffraktive Fläche (422, 522, 622) eine Beugungsgittermaske aufweist.


**Revendications**

1. Dispositif de combinaison spectrale de faisceaux (SBC) (400, 500, 600) destiné à combiner une pluralité de faisceaux optiques entrants différenciés spectralement, émanant d'une pluralité de fibres optiques (410a-410f, 510a-510d, 610a-610d), **caractérisé en ce que** le dispositif SBC (400, 500, 600) comporte au moins :

- un corps monolithique (420, 520, 620), qui est au moins partiellement transparent et a :
- une surface d'entrée (421, 521, 621), reliée ou pouvant être reliée fixement à la pluralité de fibres optiques (410a-410f, 510a-510d, 610a-610d),
- une surface diffractive (422, 522, 622), et
- une surface de sortie (424, 524, 624),
dans lequel le corps monolithique (420, 520, 620) est configuré pour diriger les faisceaux optiques entrants, entrant dans celui-ci via la surface d'entrée (421, 521, 621), par un trajet optique à diffraction multiple à l'intérieur du corps monolithique (420, 520, 620) en dirigeant les faisceaux optiques entrants de manière à frapper au moins deux fois la surface diffractive (422, 522), pour combiner les faisceaux optiques entrants en un seul faisceau optique de sortie combiné multispectral, sortant du corps monolithique (420, 520, 620) via sa surface de sortie, et

dans lequel le corps monolithique (420, 520, 620) est en outre **caractérisé en ce qu'**il est configuré pour combiner les faisceaux optiques entrants, en dirigeant ceux-ci sur le trajet optique à diffraction multiple, de telle sorte que tous les faisceaux optiques sortent du corps monolithique (420, 520, 620), via la surface de sortie (424, 524, 624) de celui-ci, dans des trajectoires de sortie parallèles les unes aux autres, en formant ainsi le faisceau optique de sortie combiné.

2. Dispositif SBC (400, 500, 600) selon la revendication 1, dans lequel le corps monolithique (420, 520, 620) comporte en outre : une surface réfléchissante (423, 523) positionnée de manière à réfléchir au moins une fois des faisceaux optiques, pour diriger ceux-ci vers la surface diffractive (422, 522, 622), ou de multiples surfaces réfléchissantes (623, 624b) configurées pour une réflexion totale interne (TIR) ou pour une réflexion partielle interne (PIR).

3. Dispositif SBC (600) selon l'une quelconque ou plusieurs des revendications 1 à 2, dans lequel la surface de sortie est **caractérisée en ce qu'**elle a une zone réfléchissante (624b) et une zone transparente (624a), positionnées de manière à réfléchir des faisceaux optiques frappant la zone réfléchissante (624b) pour retourner dans le corps monolithique (620) pour être redirigés vers la surface diffractive (622), et pour permettre à des faisceaux optiques dirigés vers la zone transparente (624a) de sortir du corps monolithique (620) à partir de celle-ci.

4. Dispositif SBC (400, 500, 600) selon l'une quelconque ou plusieurs des revendications 1 à 3, dans lequel les faisceaux optiques entrants sont de différentes longueurs d'onde ou de différentes bandes de longueurs d'onde, en étant ainsi différenciés spectralement les uns des autres, et dans lequel la surface diffractive du corps monolithique (420, 520, 620) est **caractérisée en ce qu'**elle est conçue en fonction des différences entre les longueurs d'onde des faisceaux optiques entrants.

5. Dispositif SBC (400, 500, 600) selon l'une quelconque ou plusieurs des revendications 1 à 4, dans lequel la surface diffractive (422, 522, 622) comporte un masque de réseau de diffraction.

FIG. 1
(BACKGROUND ART)

FIG. 2

FIG. 3A

FIG. 3B

FIG. 3C

FIG. 4

FIG. 5

FIG. 6

FIG. 7

FIG. 8

9000

9110a

9100A
CBC
Device

9120a

9110b

9100B
CBC
Device

9120b

9400
CBC
Device

9500

9110c

9100C
CBC
Device

9120c

FIG. 9

FIG. 10A
(Background Art)

FIG. 10B
(Background Art)

FIG. 11

500

510a

510b

510c

510d

y5

521

522

520

524

525

523

550

FIG. 12

FIG. 13

FIG. 14

Providing a CBC device that has a monolithic body and a phase mask, where the phase mask is configured to combine coherent optical beams. <u>801</u>

Directing multiple coherent optical beams into the monolithic body (e.g. by using waveguides), at a specific entry angle in respect to a main axis. <u>802</u>

Directing the entering optical beams inside the monolithic body such that the entering beams converge into a focal point defining a focal plane, where the phase mask of the CBC device being located over the focal plane. <u>803</u>

Combining the optical beams impinging the phase mask of the CBC device <u>804</u>

Outputting a single coherent combined output optical beam and directing thereof externally from the CBC device. <u>805</u>

FIG. 15

Providing a SBC device that has a monolithic body having at least an input surface, an output surface and a diffractive surface, where the SBC device is configured for SBC via a multi-diffraction optical pathway.    <u>811</u>

Directing multiple spectrally differentiated optical beams into the monolithic body    <u>812</u>

Combining the entering optical beams by directing thereof inside the monolithic body through a multi-diffraction optical pathway by directing the entering optical beams such as to impinge the diffractive surface at least twice    <u>813</u>

Outputting a single multispectral combined output optical beam and directing thereof externally from the SBC device.    <u>814</u>

FIG. 16

Providing a first set of coherent beam combining (CBC) devices, each may include a monolithic body and a phase mask, being configured to combine a plurality of coherent entering optical beams into a single coherent combined output optical beam where the output optical beams are spectrally the same, overlapping or differentiated     821

Providing at least one additional combining device (e.g. SBC/CBC device) configured for combining  all combined output optical beams outputted by the first set of CBC devices and directed thereto and for outputting a final combined output optical beam.     822

Directing the optical beams emanating from the first set of CBC devices, towards an input surface of the at least one additional combining device     823

Combining the optical beams directed and entering the at least one additional combining device.     824

Outputting a single combined final output optical beam and directing thereof externally from the monolithic body of the at least one additional combining device.     825

FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007100752 A2, Northrop Grumman
- CN 101159365 A
- US 2017082863 A1, Marciante John R
- US 2004141681 A1, Weverka Rober T
- WO 0029888 A1
- CN 107240856 A, Yu Na

### Non-patent literature cited in the description

- **J. AUGST ; S. M. REDMOND ; C. X. YU ; D. J. RIPIN ; T. Y. FAN ; G. D. GOODNO§ ; P. A. THIELEN§ ; J. E. ROTHENBERG§ ; A. SANCHEZ §.** Coherent and Spectral Beam Combining of Fiber Lasers. Northrop Grumman Aerospace Systems, MIT Lincoln Laboratory